# EUROPEAN PATENT APPLICATION

(11) **EP 4 361 902 A1**
(43) Date of publication of application: **01.05.2024**
(21) Application number: 22828353.7
(22) Date of filing: 17.06.2022
(51) Int. Cl.: G06N 10/40

(54) **QUANTUM DEVICE, QUANTUM BIT READOUT DEVICE, AND ELECTRONIC CIRCUIT**

(30) Priority: 24.06.2021 JP 2021104978
(71) Applicant: Teikyo University, Tokyo 173-8605 (JP)
(72) Inventor: TANAMOTO, Tetsufumi, Utsunomiya-shi, Tochigi 320-8551 (JP)
(74) Representative: Sonnenberg Harrison Partnerschaft mbB
(86) International application number: PCT/JP2022/024351
(87) International publication number: WO 2022/270436

(57) **Abstract**

A difference between a state of a first quantum bit and a state of a second quantum bit is accurately determined by comparing a signal obtained by amplifying a signal indicating the state of the first quantum bit with a signal obtained by amplifying a signal indicating the state of the second quantum bit, and specifically, an input signal inverted with respect to an input signal of a first quantum circuit is set to an input signal of a second quantum circuit such that an output of the first quantum circuit and an output of the second quantum circuit are inverted between logical values of 0 and 1 through a determination unit, so that an accuracy rate of readout of a state of a quantum bit is improved. A quantum device includes a first quantum circuit, a second quantum circuit, and a latch circuit connected to the first quantum circuit and the second quantum circuit, in which the latch circuit has a function of latching a state of a first quantum bit output from the first quantum circuit and amplifying a signal indicating the state of the first quantum bit, and a function of latching a state of a second quantum bit output from the second quantum circuit and amplifying a signal indicating the state of the second quantum bit.

## Description

### TECHNICAL FIELD

The present invention relates to a quantum device, a quantum bit readout device, and an electronic circuit.

Priority is claimed on Japanese Patent Application No. 2021-104978, filed June 24, 2021, the content of which is incorporated herein by reference.

### BACKGROUND ART

Researches and developments on quantum computers and quantum annealing machines are progressing. For example, Non Patent Document 1 reports an example in which two logical operations of semiconductor quantum bits are performed, and, in addition, Non Patent Document 2 reports an example in which 50 or more quantum bits using a superconductor are produced. In addition, Non Patent Document 3 is an experimental example of a quantum annealing machine, and this technology has already been commercialized.

As the technology on the quantum computers, the development of related technology using superconductors progresses as in this example. This is because the time (coherence time) required to maintain the quantum state is experimentally and relatively easily realized in a superconducting state without resistance. However, in superconducting devices, it is difficult to perform large scale integration.

FIG. 1 of Patent Document 1 describes an electrical gate pulse line connected to a quantum bit structure for executing a quantum operation. However, Patent Document 1 describes that a change in capacitance is monitored during execution of writing, but, in the technology described in Patent Document 1, amplification of a signal that shows the state of quantum bits is not performed as an integrated circuit. Therefore, in the technology described in Patent Document 1, it is not possible as an integrated circuit to accurately determine a difference between the states of the quantum bits and to improve the accuracy rate of readout of the state of the quantum bits.

A pair of cross-coupled single electronic elements is described in FIG. 1 of Non Patent Document 4. However, in the technology described in Non Patent Document 4, a single electronic element is applied as a memory, similar to a static random access memory (SRAM). Therefore, in the technology described in Non Patent Document 4, it is not possible to read a difference in potential between a pair of single electronic elements by using the single electronic element as a sensor, and the state of the quantum bits of a quantum circuit connected to the single electronic element cannot be read out.

Non Patent Document 5 describes readout of spin quantum bits (detection of the spin state of quantum bits). In addition, Non Patent Document 5 describes that in the conversion from spin to charge, the spin state is detected through the influence of the movement of the charge, and the electron spin can be measured. However, in the technology described in Non Patent Document 5, the signal indicating the spin state of the quantum bit is not amplified as an integrated circuit. Therefore, with the technology described in Non Patent Document 5, it is not possible to accurately determine a difference in the spin states of the quantum bits and to improve the accuracy rate of readout of the spin states of the quantum bits.

Non Patent Documents 6 and 7 describe technology for reading out quantum bits. In the technology described in Non Patent Document 6, since the current change of the Coulomb blockade phenomenon is as small as pA, multiple subsequent stage amplifier circuits are assembled to perform multiplexing amplification of signals. Thus, in the technology described in Non Patent Documents 6 and 7, the circuit area is significantly large in a case where the number of quantum bits is large, which is unrealistic.

### CITATION LIST

### PATENT DOCUMENT

Patent Document 1
United States Patent No. 7830695

### NON PATENT DOCUMENTS

Non Patent Document 1
   M. Veldhorst, C. H. Yang, J. C. C. Hwang, W. Huang, J. P. Dehollain, J. T. Muhonen, S. Simmons, A. Laucht, F. E. Hudson, K. M. Itoh, A. Morello & A. S. Dzurak "A two-qubit logic gate in silicon" Nature volume 526, pages 410-414 (2015)
Non Patent Document 2
   Frank Arute, Kunal Arya, et al. "Quantum supremacy using a programmable superconducting processor" Nature volume 574, pages 505-510 (2019)
Non Patent Document 3
   M. W. Johnson et al. "Quantum annealing with manufactured spins" Nature vol 473, pp.194-198 (2011).
Non Patent Document 4
   Souvik Mahapatra, A.M. Ionescu "A novel single electron SRAM architecture" Materials Science (2004), 4th IEEE Conference on Nanotechnology, 2004 DOI:10.1109/NANO.2004.1392327 Corpus ID:20005522
Non Patent Document 5
   Nakul Shaji et al. "Spin blockade and lifetime-enhanced transport in a few-electron Si/SiGe double quantum dot" Nature Physics 4, 540-544 (2008)
Non Patent Document 6
   Andrea Ruffino et al. "A Fully-integrated 40-nm 5-6.5 GHz Cryo-CMOS system-on-Chip with I/Q Receiver and Frequency Synthesizer for Scalable Multiplexed Readout of Quantum Dots" 2021 IEEE international Solid-State Circuits Conference (ISSCC)
Non Patent Document 7]
   Andrea Morello et al. "Single-shot readout of an electron spin in silicon" Nature vol 467.p687 (2010)
[Non Patent Document 8
   T Tanamoto, Y Nishi, J Deguchi "Quantum Annealing Machines Based on Semiconductor Nanostructures" Journal of the Physical Society of Japan 88 (6), 061013 (2019)
Non Patent Document 9
   Behzad Razavi "Design of Analog CMOS Integrated Circuits" (MCGRAW HILL BOOK CO, 2000) ISBN: 9780072380323

### SUMMARY OF INVENTION

### Technical Problem]

In view of the above-described point, an object of the present invention is to provide a quantum device capable of improving the accuracy rate of readout of the state of quantum bits by accurately determining the difference between the state of a first quantum bit and the state of a second quantum bit, and operating a second quantum circuit such that a logical value of the output of a first quantum circuit and a logical value of the output of the second quantum circuit are inverted between 0 and 1.

In addition, an object of the present invention is to provide a quantum bit readout device capable of reading out the state of the quantum bit of the quantum circuit connected to a single electronic element while the circuit is minimized, by reading the difference between the potential of a first single electronic element and the potential of a second single electronic element.

In addition, an object of the present invention is to provide an electronic circuit capable of reading the difference between the potential of the first single electronic element and the potential of the second single electronic element.

### Solution to Problem

According to an aspect of the present invention, a quantum device includes a first quantum circuit, a second quantum circuit, and a latch circuit connected to the first quantum circuit and the second quantum circuit, in which the latch circuit has a function of latching a state of a first quantum bit output from the first quantum circuit and amplifying a signal indicating the state of the first quantum bit, and a function of latching a state of a second quantum bit output from the second quantum circuit and amplifying a signal indicating the state of the second quantum bit.

According to an aspect of the present invention, a quantum bit readout device includes a first single electronic element connected to a first quantum circuit, a second single electronic element connected to a second quantum circuit, and a differential amplifier circuit connected to the first single electronic element and the second single electronic element, in which a difference between a potential of the first single electronic element and a potential of the second single electronic element amplified by the differential amplifier circuit is read.

The quantum bit readout device according to the aspect of the present invention may include a first amplifier circuit disposed between the first single electronic element and the differential amplifier circuit, and a second amplifier circuit disposed between the second single electronic element and the differential amplifier circuit.

In the quantum bit readout device of the aspect of the present invention, the first amplifier circuit may include a first conductive transistor and a second conductive transistor, and the second amplifier circuit may include the first conductive transistor and the second conductive transistor.

According to an aspect of the present invention, a quantum bit readout device includes a first single electronic element connected to a first quantum circuit, a second single electronic element connected to a second quantum circuit, and a static random access memory (SRAM) connected to the first single electronic element and the second single electronic element, in which a difference between a potential of the first single electronic element and a potential of the second single electronic element output via the SRAM is read.

In the quantum bit readout device according to the aspect of the present invention, the SRAM may include a first access transistor connected to the first single electronic element, a second access transistor connected to the second single electronic element, a first inverter connected to the first access transistor, and a second inverter connected to the second access transistor, and the first inverter and the second inverter may be cross-coupled.

The quantum bit readout device according to the aspect of the present invention may include a first amplifier circuit disposed between the first single electronic element and the SRAM, and a second amplifier circuit disposed between the second single electronic element and the SRAM.

According to an aspect of the present invention, the quantum bit readout device includes a sense amplifier and an equalizer connected to a first single electronic element connected to a first quantum circuit and a second single electronic element connected to a second quantum circuit, in which a difference between a potential of the first single electronic element and a potential of the second single electronic element output via the sense amplifier and the equalizer is read.

In the quantum bit readout device of the aspect of the present invention, the sense amplifier and the equalizer may include the same one as a general more complicated dynamic random access memory (DRAM). A general DRAM uses a circuit that reads a difference between the charges accumulated in two capacitors. The feature of the present invention is to use a single electronic element instead of the capacitors of a normal DRAM. In particular, in a case where the single electronic element is a charge quantum bit, it is useful for reading a small potential difference between the charge quantum bits.

According to an aspect of the present invention, the quantum bit readout device includes a first single electronic element connected to a first quantum circuit, a second single electronic element connected to a second quantum circuit, and a cross-coupled MOS transistor circuit connected to the first single electronic element and the second single electronic element, in which the cross-coupled MOS transistor circuit includes a pair of cross-coupled P-channel MOS transistors, and a difference between a potential of the first single electronic element and a potential of the second single electronic element, which are output via the cross-coupled MOS transistor circuit is read.

In the quantum bit readout device according to the aspect of the present invention, the differential amplifier circuit may include a first bipolar transistor having a base connected to the first single electronic element and a second bipolar transistor having a base connected to the second single electronic element.

In the quantum bit readout device according to the aspect of the present invention, the potential of the first single electronic element and the potential of the second single electronic element may be output as a result of inversion.

The quantum bit readout device according to the aspect of the present invention may include a determination unit configured to perform determination between 0 and 1 by comparing the potential of the first single electronic element with the potential of the second single electronic element.

According to an aspect of the present invention, an electronic circuit includes a first memory cell array, a first selector configured to select a first single electronic element from the first memory cell array, a second memory cell array, and a second selector configured to select a second single electronic element from the second memory cell array, in which a difference between a potential of the first single electronic element selected by the first selector and a potential of the second single electronic element selected by the second selector is read.

The electronic circuit according to the aspect of the present invention may include a determination unit configured to perform determination between 0 and 1 by comparing the potential of the first single electronic element with the potential of the second single electronic element.

The above-described quantum bit may be a spin quantum bit, and the single electronic element may be a charge quantum bit itself. In a case where the quantum bit is a spin quantum bit, the quantum bit may be coupled to the single electronic element via a tunnel oxide or the like.

### Advantageous Effects of Invention

According to the present invention, there is provided a quantum device capable of improving the accuracy rate of readout of the state of a quantum bit by accurately determining the difference between the state of a first quantum bit and the state of a second quantum bit and adjusting an input signal of a second quantum circuit such that the output of a first quantum circuit and the output of the second quantum circuit are inverted between logical values of 0 and 1.

In addition, according to the present invention, there can be provided a quantum bit readout device capable of reading out the state of the quantum bit of the quantum circuit connected to a single electronic element while the circuit is minimized, by reading the difference between the potential of a first single electronic element and the potential of a second single electronic element.

In addition, according to the present invention, there is provided an electronic circuit capable of reading the difference between the potential of the first single electronic element and the potential of the second single electronic element.

### BRIEF DESCRIPTION OF DRAWINGS

FIG. 1 is a diagram representing an example of a quantum device according to a first embodiment.
FIG. 2 is a diagram representing an example of a quantum bit readout device or the like of the first embodiment.
FIG. 3 is a diagram for explaining an example of characteristics of a single electronic element (specifically, a single electron transistor (SET)) such as the single electronic element represented in FIG. 2.
FIG. 4 is a diagram for explaining a principle of a first amplifier circuit by MOS coupling, such as an amplifier circuit (P-channel MOS transistor) represented in FIG. 2.
FIG. 5 is a diagram representing a relationship between a gate voltage (horizontal axis) of a single electronic element (specifically, a single electron transistor (SET)) such as the single electronic element represented in FIG. 2, and a potential (vertical axis) of an output terminal amplified by MOS coupling such as an amplifier circuit (P-channel MOS transistor) represented in FIG. 2.
FIG. 6 is a diagram representing an example of a quantum bit readout device or the like of a second embodiment.
FIG. 7 is a diagram for explaining first amplification by a P-channel MOS transistor and an N-channel MOS transistor such as the amplifier circuit represented in FIG. 6.
FIG. 8 is a diagram representing differential amplification simulation results obtained by a differential amplifier circuit represented in FIG. 6.
FIG. 9 is a diagram representing an example of a quantum bit readout device or the like of a third embodiment.
FIG. 10 is a diagram representing results of circuit simulation (time change) represented in FIG. 9.
FIG. 11 is a diagram representing an example of a quantum bit readout device or the like of a fourth embodiment.
FIG. 12 is a diagram representing an example of a quantum bit readout device or the like of a fifth embodiment.
FIG. 13 is a diagram representing an example of a quantum bit readout device or the like of a sixth embodiment.
FIG. 14 is a diagram representing an example of a quantum bit readout device or the like of a seventh embodiment.
FIG. 15 is a diagram representing an example of a quantum bit readout device or the like of an eighth embodiment.
FIG. 16 is a diagram representing an example of an electronic circuit of a ninth embodiment.
FIG. 17 is a diagram for explaining an example in which one single electronic element (a first single electronic element 3A1) among a plurality of single electronic elements included in a first single electronic element array 3A is used as a single electronic element 2A according to the first to ninth embodiments, and one single electronic element (a second single electronic element 3C1) among a plurality of single electronic elements included in a second single electronic element array 3C is used as a single electronic element 2B in the first to ninth embodiments.
FIG. 18 is a diagram representing a time change of a voltage in the quantum bit readout device of the sixth embodiment represented in FIG. 13.
FIG. 19 is a diagram for explaining an example in which a NAND flash memory is used as a first single electronic element array and a NAND flash memory is used as a second single electronic element array in the electronic circuit of the ninth embodiment.
FIG. 20 is a diagram schematically representing a situation in which a potential in a single electronic element shifts due to presence or absence of electrons in a quantum dot connected to the single electronic element.

### DESCRIPTION OF EMBODIMENTS

Before describing embodiments of a quantum device, a quantum bit readout device, and an electronic circuit of the present invention, related art relating to measurement or the like of the quantum device will be described.

### Related Art Relating to Measurement

Development has been slow for quantum bits using electron spins or hole spins. This is because quantum devices using spins have had a difficult problem in a measurement process for spin states. Electronic circuits are required to measure the spin states, but although the spins have a magnetic property, normal electronic circuits do not have a mechanism that directly measures the quantity relating to magnetization, so that it was necessary to convert the magnetic property into a charge state.

Specifically, there is a method or the like referred to as spin blockade. This method is a method utilizing the fact that when one quantum dot is added and the direction of an electron spin inside is fixed, electrons are blocked or flow depending on whether the spin coming from the quantum bit is upward or downward. This is on the basis of the Pauli's exclusion principle, which states that two electrons with the same spin directions cannot occupy the same energy level.

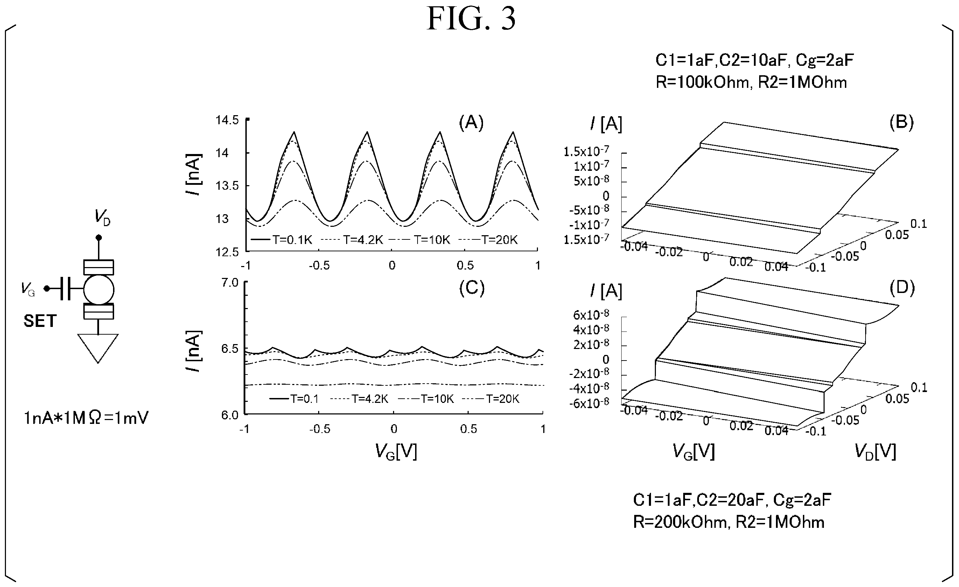

However, as represented in FIG. 3, a current value of a single electronic element that can observe the Coulomb blockade is in the order of nanoamperes, and a voltage thereof is extremely small as compared with a voltage region in which a normal CMOS circuit operates. Therefore, in order to amplify a minute signal of one single electronic element, multiple layers of amplifier circuits as in Non Patent Document 6 are required. Since this method in related art requires an extremely large number of circuit areas to amplify the signal of only one single electron, it is difficult to integrate the quantum bits.

### Manufacturing Cost

Moreover, in novel device structures, major challenges remain in production. In Non Patent Document 1, Non Patent Document 3, or the like, novel hyperfine structures are required. The gate length of silicon transistors used in current smartphones is 16 nm or less, and the chip production costs more than 1 trillion yen. About 400 billion yen is required in even 40 nm. Designing a new amplifier circuit from the beginning is expected to require huge development costs, which is a major obstacle to industrialization. Therefore, it is desirable to use the circuit in related art as much as possible.

Hereinafter, embodiments of a quantum device, a quantum bit readout device, and an electronic circuit of the present invention will be described.

### First Embodiment

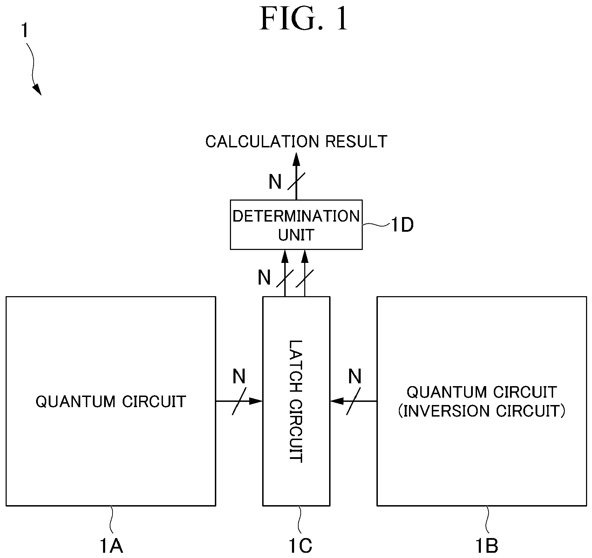

FIG. 1 is a diagram representing an example of a quantum device 1 of a first embodiment.

In the example represented in FIG. 1, the quantum device 1 of the first embodiment includes a quantum circuit 1A, a quantum circuit 1B, a latch circuit 1C, and a determination unit 1D. The latch circuit 1C is connected to the quantum circuit 1A and the quantum circuit 1B by one or more wirings. The quantum circuit 1A and the quantum circuit 1B are configured as a pair.

The latch circuit 1C has a function of latching the state of the quantum bit output from the quantum circuit 1A (the spin state in the case of the spin quantum bit and the charge state in the case of the charge quantum bit) and amplifying a signal indicating the state of the spin quantum bit. That is, the latch circuit 1C includes a circuit that amplifies a signal indicating the state of the quantum bit output from the quantum circuit 1A.

In addition, the latch circuit 1C has a function of latching the state of the quantum bit output from the quantum circuit 1B and amplifying a signal indicating the state of the quantum bit. That is, the latch circuit 1C includes a circuit that amplifies a signal indicating the state of the quantum bit output from the quantum circuit 1B.

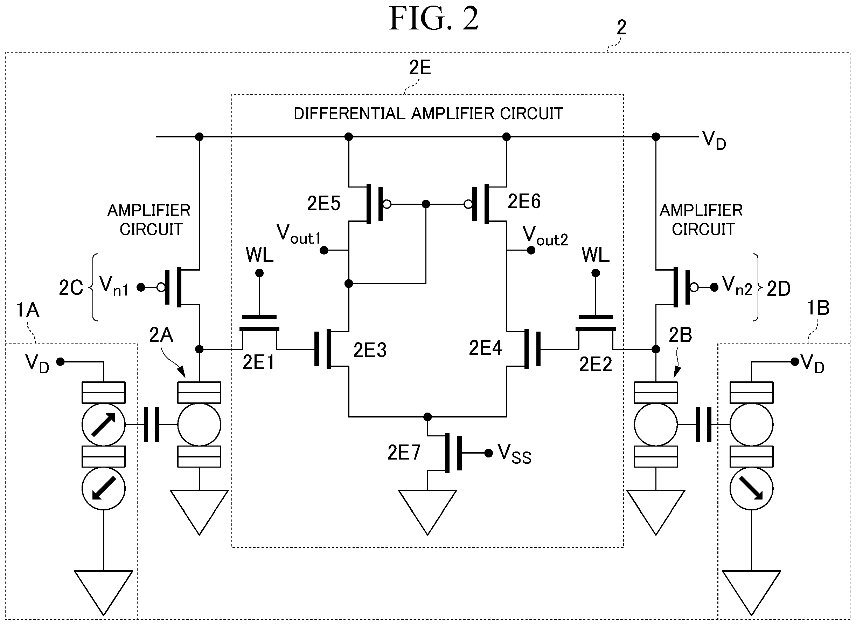

The latch circuit 1C and the determination unit 1D represented in FIG. 1 can be expressed as, for example, a quantum bit readout device 2 represented in FIG. 2. The latched value is fixed by the determination unit 1D, and is finally output as a calculation result.

FIG. 2 is a diagram representing an example of the quantum bit readout device 2 or the like of the first embodiment. Here, a case where the quantum bit is a spin quantum bit is represented.

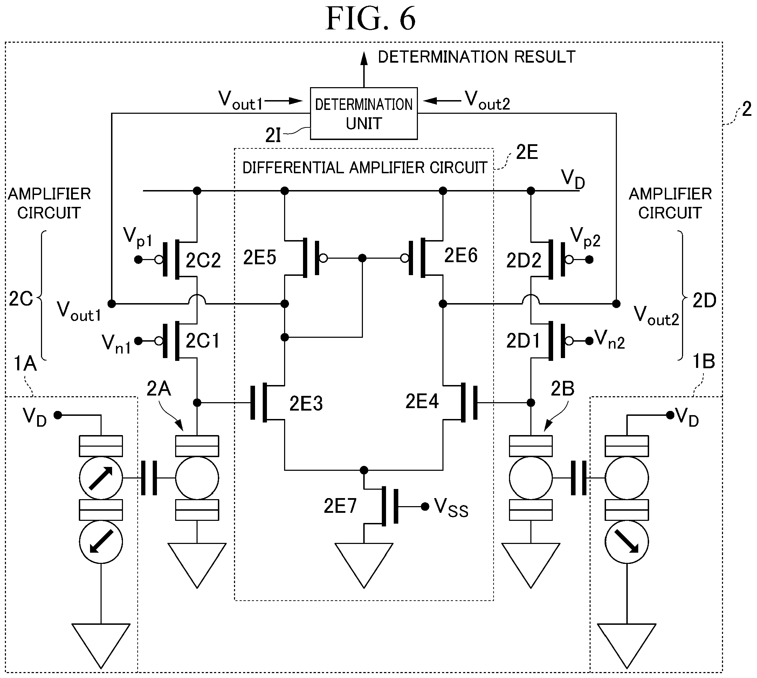

In the example represented in FIG. 2, the quantum bit readout device 2 includes a single electronic element 2A, a single electronic element 2B, an amplifier circuit 2C, an amplifier circuit 2D, a differential amplifier circuit 2E, and a determination unit 2I (see FIG. 6).

The single electronic element 2A measures the state of the spin quantum bit of the quantum circuit 1A (the spin state of the quantum bit). The gate of the single electronic element 2A is connected to the quantum circuit 1A. One of the source and the drain of the single electronic element 2A is connected to the amplifier circuit 2C functioning as a first stage amplifier circuit and the differential amplifier circuit 2E functioning as a second stage amplifier circuit. The other of the source and the drain of the single electronic element 2A is, for example, grounded.

The single electronic element 2B measures the state of the spin quantum bit of the quantum circuit 1B. The gate of the single electronic element 2B is connected to the quantum circuit 1B. One of the source and the drain of the single electronic element 2B is connected to the amplifier circuit 2D functioning as a first stage amplifier circuit and the differential amplifier circuit 2E functioning as a second stage amplifier circuit. The other of the source and the drain of the single electronic element 2B is, for example, grounded.

In the example represented in FIG. 2, the amplifier circuit 2C is disposed between the single electronic element 2A and the differential amplifier circuit 2E. The amplifier circuit 2C is configured by a P-channel MOS transistor. Specifically, one of the source and the drain of the P-channel MOS transistor that functions as the amplifier circuit 2C is connected to one of the source and the drain of the single electronic element 2A. The other of the source and the drain of the P-channel MOS transistor that functions as the amplifier circuit 2C is connected to a predetermined potential VD.

The amplifier circuit 2D is disposed between the single electronic element 2B and the differential amplifier circuit 2E. The amplifier circuit 2D is configured by a P-channel MOS transistor. Specifically, one of the source and the drain of the P-channel MOS transistor that functions as the amplifier circuit 2D is connected to one of the source and the drain of the single electronic element 2B. The other of the source and the drain of the P-channel MOS transistor that functions as the amplifier circuit 2D is connected to the predetermined potential VD.

In the example represented in FIG. 2, the quantum bit readout device 2 includes the amplifier circuit 2C and the amplifier circuit 2D, but, in another example, the quantum bit readout device 2 may not include the amplifier circuit 2C and the amplifier circuit 2D.

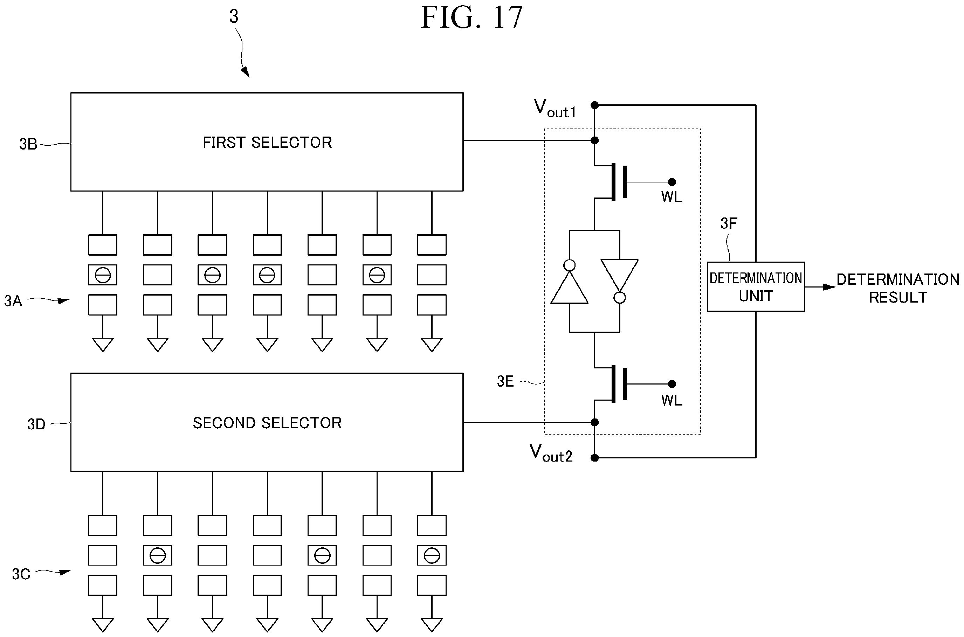

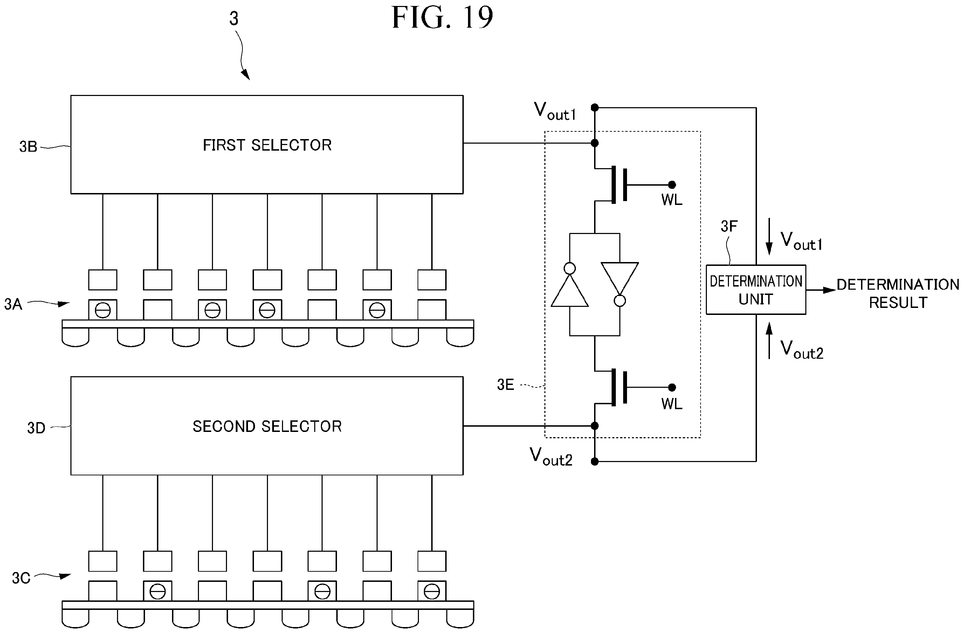

The single electronic elements 2A and 2B are generally disposed in an array as represented in FIGS. 17 and 19 described later, and it is possible to select which two single electronic elements to be selected (in FIGS. 17 and 19, the single electronic elements are indicated by reference numerals 3A1 and 3C1, and the single electronic element array is indicated by reference numerals 3A and 3C). At this time, the selected single electronic elements 2A and 2B and the amplifier circuit (N-channel MOS transistors 2E3, 2E4, or the like of the differential amplifier circuit 2E) are connected by the transistor (N-channel MOS transistors 2E1 and 2E2) that applies a voltage to a word line WL, and a signal is input to the amplifier circuit (the differential amplifier circuit 2E).

In the example represented in FIG. 2, the differential amplifier circuit 2E includes the N-channel MOS transistors 2E1, 2E2, 2E3, 2E4, and 2E7 and P-channel MOS transistors 2E5 and 2E6.

One of the source and the drain of the N-channel MOS transistor 2E1 is connected to one of the source and the drain of the single electronic element 2A. The other of the source and the drain of the N-channel MOS transistor 2E1 is connected to the gate of the N-channel MOS transistor 2E3. The gate of the N-channel MOS transistor 2E1 is connected to the word line WL.

One of the source and the drain of the N-channel MOS transistor 2E3 is connected to a first output terminal Vout1 of the differential amplifier circuit 2E, one of the source and the drain of the P-channel MOS transistor 2E5, the gate of the P-channel MOS transistor 2E5, and the gate of the P-channel MOS transistor 2E6. The other of the source and the drain of the N-channel MOS transistor 2E3 is connected to one of the source and the drain of the N-channel MOS transistor 2E7.

The other of the source and the drain of the N-channel MOS transistor 2E7 is, for example, grounded.

One of the source and the drain of the N-channel MOS transistor 2E2 is connected to one of the source and the drain of the single electronic element 2B. The other of the source and the drain of the N-channel MOS transistor 2E2 is connected to the gate of the N-channel MOS transistor 2E4. The gate of the N-channel MOS transistor 2E2 is connected to the word line WL.

One of the source and the drain of the N-channel MOS transistor 2E4 is connected to a second output terminal Vout2 of the differential amplifier circuit 2E and one of the source and the drain of the P-channel MOS transistor 2E6. The other of the source and the drain of the N-channel MOS transistor 2E4 is connected to one of the source and the drain of the N-channel MOS transistor 2E7.

The other of the source and the drain of the P-channel MOS transistor 2E5 and the other of the source and the drain of the P-channel MOS transistor 2E6 are connected to the predetermined potential VD.

The first output terminal Vout1 and the second output terminal Vout2 of the differential amplifier circuit 2E are connected to the determination unit 2I.

The differential amplifier circuit of the present invention is the most basic, and various amplifier circuits as represented in Non Patent Document 9 may be used instead.

The determination unit 2I reads a difference between the potential (the potential at the first output terminal Vout1 of the differential amplifier circuit 2E) of the single electronic element 2A amplified by the amplifier circuit 2C and the differential amplifier circuit 2E, and the potential (the potential at the second output terminal Vout2 of the differential amplifier circuit 2E) of the single electronic element 2B amplified by the amplifier circuit 2D and the differential amplifier circuit 2E.

Specifically, the potential difference between the potential of the single electronic element 2A and the potential of the single electronic element 2B is amplified by the differential amplifier circuit 2E, the amplifier circuit 2C, and the amplifier circuit 2D, and is output to the output terminals Vout1 and Vout2. That is, a potential difference between the first output terminal Vout1 and the second output terminal Vout2 is larger than a potential difference originally between the potential of the single electronic element 2A and the potential of the single electronic element 2B. Further, the determination unit 2I performs determination between "0" and "1", which is easy to handle in the subsequent digital circuit, by comparing the potential of the single electronic element 2A amplified by the amplifier circuit 2C and the differential amplifier circuit 2E with the potential of the single electronic element 2B amplified by the amplifier circuit 2D and the differential amplifier circuit 2E.

In the example represented in FIG. 2, the determination unit 2I can read out the states of the quantum bits of the quantum circuits 1A and 1B connected to the single electronic elements 2A and 2B while the entire circuit is minimized, by reading the difference between the potential of the single electronic element 2A amplified by the amplifier circuit 2C and the differential amplifier circuit 2E and the potential of the single electronic element 2B amplified by the amplifier circuit 2D and the differential amplifier circuit 2E.

In other words, in the examples represented in FIGS. 1 and 2, a difference between a signal (specifically, the potential of the first output terminal Vout1) obtained by amplifying a signal (specifically, in the case of the spin quantum bit, the signal measured and output by the single electronic element 2A and indicating the spin state of the quantum bit of the quantum circuit 1A) indicating the state of the quantum bit output from the quantum circuit 1A by the latch circuit 1C (specifically, the amplifier circuit 2C and the differential amplifier circuit 2E), and a signal (specifically, the potential of the second output terminal Vout2) obtained by amplifying a signal (specifically, in the case of the spin quantum bit, the signal measured and output by the single electronic element 2B and indicating the spin state of the quantum bit of the quantum circuit 1B) indicating the state of the quantum bit output from the quantum circuit 1B by the latch circuit 1C (specifically, the amplifier circuit 2D and the differential amplifier circuit 2E) is one obtained by more greatly amplifying a difference between the signals of the two single electronic elements 2A and 2B without the amplifier circuits, and the output results of the single electronic elements 2A and 2B, which are minute signals, are more accurately compared, so that it is possible to accurately determine the difference between the state of the (spin) quantum bit of the quantum circuit 1A and the state of the (spin) quantum bit of the quantum circuit 1B. Specifically, by inputting the input signal of the quantum circuit 1A and the input signal of the quantum circuit 1B in opposite directions such that the expected logic output of the quantum circuit 1A and the expected logic output of the quantum circuit 1B are opposite to each other, the latch circuit 1C acts such that the actual output signal is inverted between the first output terminal Vout1 and the second output terminal Vout2, so that it is possible to improve the accuracy rate of readout of the state of the quantum bit.

FIG. 3 is a diagram for explaining an example of characteristics of a single electronic element (specifically, a single electron transistor (SET)) such as the single electronic element 2A represented in FIG. 2. Specifically, parts (A) and (B) FIG. 3 represent I-V in a case where the capacitances of the two tunnel films of the single electronic element are 1aF and 10aF, the gate capacitance is 2aF, and the resistances of the tunnel films are 100kS2 and 1MQ, with the dependence of the gate voltage (the part (A) of FIG. 3) and the dependence of a gate voltage VG and the drain voltage (the part (B) of FIG. 3). Parts (C) and (D) of FIG. 3 represent I-V in a case where the capacitances of the two tunnel films of the single electronic element are 1aF and 20aF, the gate capacitance is 2aF, and the resistances of the tunnel films are 200kS2 and 1MQ, with the dependence of the gate voltage (the part (C) of FIG. 3) and the dependence of the gate voltage VG and the drain voltage (the part (D) of FIG. 3). As represented in the figure, a current value flowing through the single electronic element is in the order of nanoamperes, and is smaller than that in normal CMOS. Here, aF stands for attofarad and indicates 10-18 F.

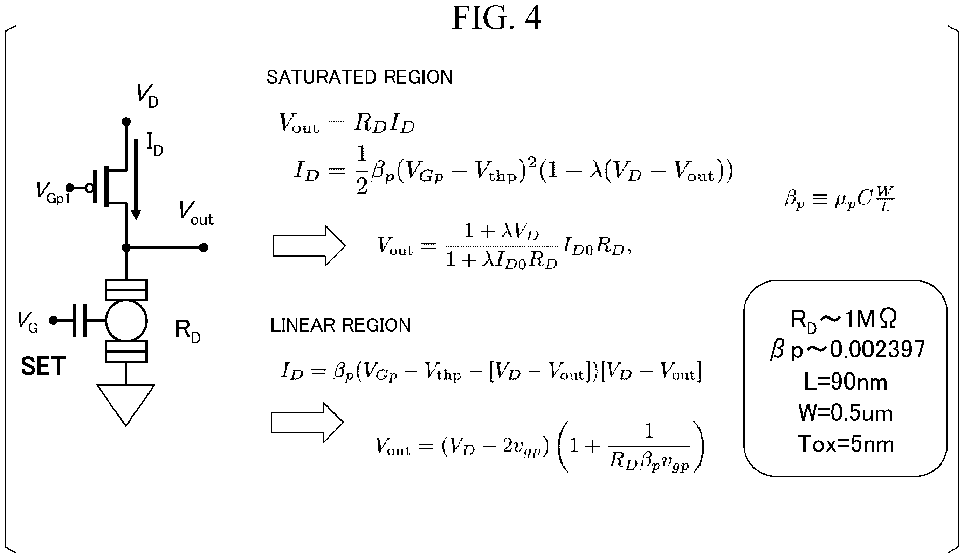

FIG. 4 is a diagram for explaining the principle of a first amplifier circuit by MOS transistor coupling, such as the amplifier circuit 2C (P-channel MOS transistor) represented in FIG. 2. According to one of the features of the present invention, instead of directly connecting the two single electronic elements to the second amplifier circuit, the single electronic element is first connected to a MOS transistor in series, and, after the potential of the single electronic element is increased or decreased, is connected to the second amplifier circuit. The reason for this is that, as described in FIG. 3, the current value of the single electronic element is in the order of nanoamperes, which is different from the regions of current and voltage used in a normal CMOS circuit. When the single electronic element is directly connected to the second amplifier circuit, the output signal of the single electronic element enters the level of the noise signal of the second amplifier circuit, and it is not possible to accurately determine the signal of the single electronic element. By connecting the MOS transistor in the first amplifier circuit, it is possible to stably connect the MOS transistor to the second amplifier circuit. FIG. 4 represents the amplification principle in a saturated region and the amplification principle in a linear region.

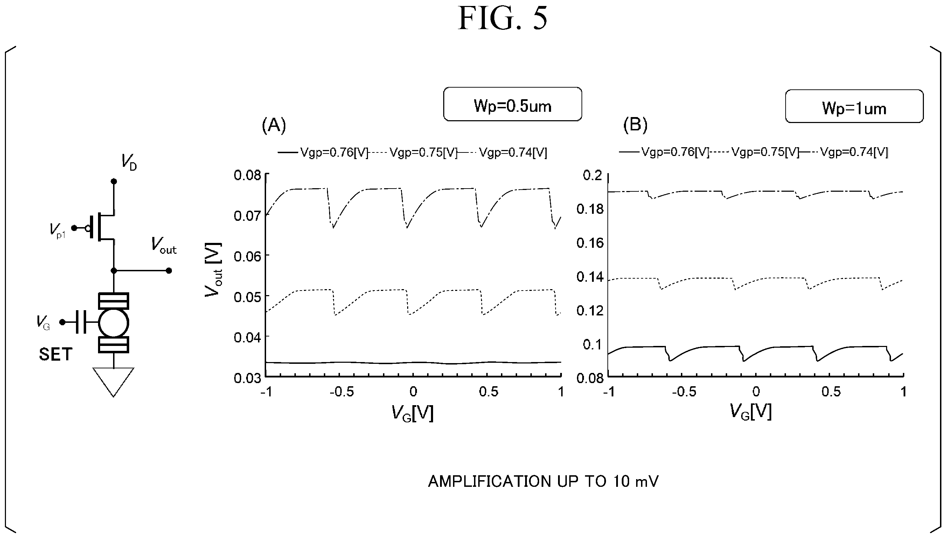

FIG. 5 is a diagram representing a relationship between a gate voltage VG [V] (horizontal axis) of a single electronic element (specifically, a single electron transistor (SET)) such as the single electronic element 2A represented in FIG. 2, and a potential Vout [V] (vertical axis) of an output terminal amplified by MOS transistor coupling such as the amplifier circuit 2C (P-channel MOS transistor) represented in FIG. 2. Specifically, a part (A) of FIG. 5 represents a relationship between the gate voltage VG [V] (horizontal axis) and the potential Vout [V] (vertical axis) of the output terminal in a case where a gate width Wp of the P-channel MOS transistor of the amplifier circuit is set to 0.5 µm, and a part (B) of FIG. 5 represents a relationship between the gate voltage VG [V] (horizontal axis) and the potential Vout [V] (vertical axis) of the output terminal in a case where the gate width Wp of the P-channel MOS transistor of the amplifier circuit is set to 1 µm. As represented in FIG. 5, the potential Vout in the saturation region is higher than the potential Vout in the linear region.

### Second Embodiment

Hereinafter, the second embodiment of the quantum device, the quantum bit readout device, and the electronic circuit of the present invention will be described.

The quantum device 1 and the quantum bit readout device 2 of the second embodiment are configured in the same manner as the quantum device 1 and the quantum bit readout device 2 of the first embodiment described above, except for points described below. Therefore, according to the quantum device 1 and the quantum bit readout device 2 of the second embodiment, the same effects as those of the quantum device 1 and the quantum bit readout device 2 of the first embodiment described above can be obtained, except for the points described below.

FIG. 6 is a diagram representing an example of the quantum bit readout device 2 or the like of the second embodiment. The latch circuit 1C and the determination unit 1D of the quantum device 1 of the second embodiment can be expressed as, for example, the quantum bit readout device 2 represented in FIG. 6.

In the example represented in FIG. 6, the quantum bit readout device 2 includes the single electronic element 2A, the single electronic element 2B, the amplifier circuit 2C, the amplifier circuit 2D, the differential amplifier circuit 2E, and the determination unit 2I. The amplifier circuit 2C includes an N-channel MOS transistor 2C1 and a P-channel MOS transistor 2C2. The amplifier circuit 2D includes an N-channel MOS transistor 2D1 and a P-channel MOS transistor 2D2. The differential amplifier circuit 2E includes the N-channel MOS transistors 2E3, 2E4, and 2E7 and the P-channel MOS transistors 2E5 and 2E6.

The single electronic element 2A measures a state of the spin quantum bit of the quantum circuit 1A. The gate of the single electronic element 2A is connected to the quantum circuit 1A. One of the source and the drain of the single electronic element 2A is connected to one of the source and the drain of the N-channel MOS transistor 2C1 of the amplifier circuit 2C that functions as a first stage amplifier circuit, and to the gate of the N-channel MOS transistor 2E3 of the differential amplifier circuit 2E that functions as a second stage amplifier circuit. The other of the source and the drain of the single electronic element 2A is, for example, grounded.

The single electronic element 2B measures the state of the spin quantum bit of the quantum circuit 1B. The gate of the single electronic element 2B is connected to the quantum circuit 1B. One of the source and the drain of the single electronic element 2B is connected to one of the source and the drain of the N-channel MOS transistor 2D1 of the amplifier circuit 2D that functions as a first stage amplifier circuit, and to the gate of the N-channel MOS transistor 2E4 of the differential amplifier circuit 2E that functions as a second stage amplifier circuit. The other of the source and the drain of the single electronic element 2B is, for example, grounded.

In the example represented in FIG. 6, the amplifier circuit 2C is disposed between the single electronic element 2A and the differential amplifier circuit 2E. Specifically, the other of the source and the drain of the N-channel MOS transistor 2C1 of the amplifier circuit 2C is connected to one of the source and the drain of the P-channel MOS transistor 2C2. The other of the source and the drain of the P-channel MOS transistor 2C2 is connected to the predetermined potential VD.

The amplifier circuit 2D is disposed between the single electronic element 2B and the differential amplifier circuit 2E. Specifically, the other of the source and the drain of the N-channel MOS transistor 2D1 of the amplifier circuit 2D is connected to one of the source and the drain of the P-channel MOS transistor 2D2. The other of the source and the drain of the P-channel MOS transistor 2D2 is connected to the predetermined potential VD.

One of the source and the drain of the N-channel MOS transistor 2E3 is connected to a first output terminal Vout1 of the differential amplifier circuit 2E, one of the source and the drain of the P-channel MOS transistor 2E5, the gate of the P-channel MOS transistor 2E5, and the gate of the P-channel MOS transistor 2E6. The other of the source and the drain of the N-channel MOS transistor 2E3 is connected to one of the source and the drain of the N-channel MOS transistor 2E7.

The other of the source and the drain of the N-channel MOS transistor 2E7 is, for example, grounded.

One of the source and the drain of the N-channel MOS transistor 2E4 is connected to a second output terminal Vout2 of the differential amplifier circuit 2E and one of the source and the drain of the P-channel MOS transistor 2E6. The other of the source and the drain of the N-channel MOS transistor 2E4 is connected to one of the source and the drain of the N-channel MOS transistor 2E7.

The other of the source and the drain of the P-channel MOS transistor 2E5 and the other of the source and the drain of the P-channel MOS transistor 2E6 are connected to the predetermined potential VD.

The first output terminal Vout1 and the second output terminal Vout2 of the differential amplifier circuit 2E are connected to the determination unit 2I.

The determination unit 2I reads the difference between the potential (the potential at the first output terminal Vout1 of the differential amplifier circuit 2E) of the single electronic element 2A amplified by the N-channel MOS transistor 2C1 and the P-channel MOS transistor 2C2 of the amplifier circuit 2C and the differential amplifier circuit 2E, and the potential (the potential at the second output terminal Vout2 of the differential amplifier circuit 2E) of the single electronic element 2B amplified by the N-channel MOS transistor 2D1 and the P-channel MOS transistor 2D2 of the amplifier circuit 2D and the differential amplifier circuit 2E.

Specifically, the potential difference between the first output terminal Vout1 and the second output terminal Vout2 of the differential amplifier circuit 2E can be larger than the potential difference originally between the potential of the single electronic element 2A and the potential of the single electronic element 2B, by the differential amplifier circuit 2E, the N-channel MOS transistor 2C1 and the P-channel MOS transistor 2C2 of the amplifier circuit 2C, and the N-channel MOS transistor 2D1 and the P-channel MOS transistor 2D2 of the amplifier circuit 2D. Further, the determination unit 2I performs determination between "0" and " 1 ", which are easy to handle in a digital circuit in the subsequent stage, by comparing the potential of the single electronic element 2A amplified by the N-channel MOS transistor 2C1 and the P-channel MOS transistor 2C2 of the amplifier circuit 2C and the differential amplifier circuit 2E with the potential of the single electronic element 2B amplified by the N-channel MOS transistor 2D1 and the P-channel MOS transistor 2D2 of the amplifier circuit 2D and the differential amplifier circuit 2E.

In the example represented in FIG. 6, the determination unit 2I can read out the states of the quantum bits of the quantum circuits 1A and 1B connected to the single electronic elements 2A and 2B while the entire circuit is minimized, by reading the difference between the potential of the single electronic element 2A amplified by the N-channel MOS transistor 2C1 and the P-channel MOS transistor 2C2 of the amplifier circuit 2C and the differential amplifier circuit 2E, and the potential of the single electronic element 2B amplified by the N-channel MOS transistor 2D1 and the P-channel MOS transistor 2D2 of the amplifier circuit 2D and the differential amplifier circuit 2E.

In other words, in the second embodiment, the signal (specifically, the potential of the first output terminal Vout1) obtained by amplifying the signal (specifically, in the case of the spin quantum bit, the signal measured and output by the single electronic element 2A and indicating the spin state of the quantum bit of the quantum circuit 1A) indicating the state of the quantum bit output from the quantum circuit 1A by the latch circuit 1C (specifically, the N-channel MOS transistor 2C1 and the P-channel MOS transistor 2C2 of the amplifier circuit 2C and the differential amplifier circuit 2E), is compared with the signal (specifically, the potential of the second output terminal Vout2) obtained by amplifying a signal (specifically, in the case of the spin quantum bit, the signal measured and output by the single electronic element 2B and indicating the spin state of the quantum bit of the quantum circuit 1B) indicating the state of the quantum bit output from the quantum circuit 1B by the latch circuit 1C (specifically, the N-channel MOS transistor 2D1 and the P-channel MOS transistor 2D2 of the amplifier circuit 2D and the differential amplifier circuit 2E), so that it is possible to accurately determine the difference between the state of the (spin) quantum bit of the quantum circuit 1A and the state of the (spin) quantum bit of the quantum circuit 1B. Specifically, by inputting the input signal of the quantum circuit 1A to the input signal of the quantum circuit 1B through, for example, an inverter (that is, by using the inverted one of the input signal of the quantum circuit 1A as the input signal of the quantum circuit 1B) such that the output of the quantum circuit 1A and the output of the quantum circuit 1B are inverted between 0 and 1 through the determination unit 2I, it is possible to improve the accuracy rate of readout of the state of the quantum bit.

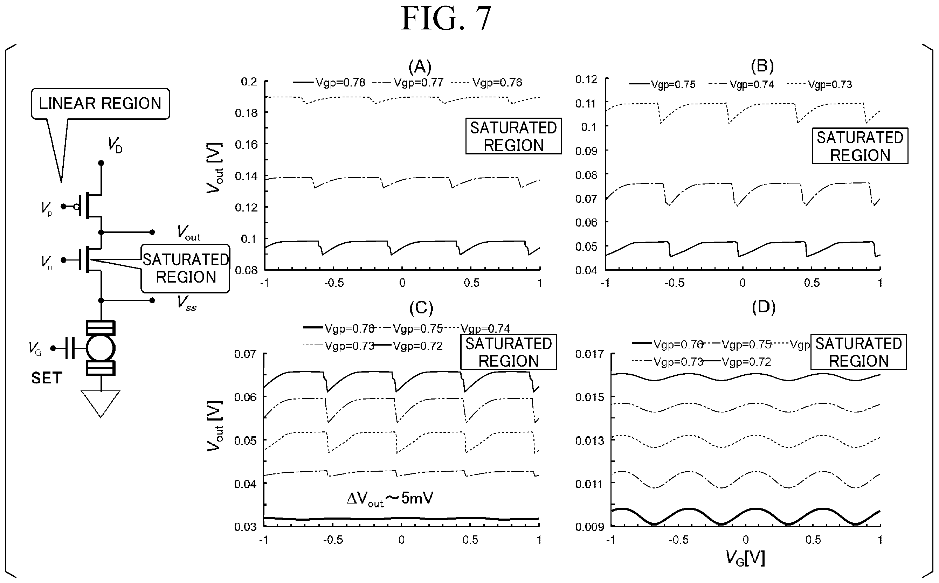

FIG. 7 is a diagram for explaining first amplification by a P-channel MOS transistor and an N-channel MOS transistor such as the amplifier circuit 2C represented in FIG. 6. Specifically, a part of (A) of FIG. 7 represents a relationship between the gate voltage VG [V] (horizontal axis) of the single electronic element (SET) in a saturation region under a predetermined condition and the potential Vout [V] (vertical axis) of an amplified output terminal. A part of (B) of FIG. 7 represents a relationship between the gate voltage VG [V] (horizontal axis) of the single electronic element (SET) in a saturation region under conditions different from those of in the part of (A) of FIG. 7 and the potential Vout [V] (vertical axis) of an amplified output terminal. A part of (C) of FIG. 7 represents a relationship between the gate voltage VG [V] (horizontal axis) of the single electronic element (SET) in a linear region under a predetermined condition and the potential Vout [V] (vertical axis) of an amplified output terminal. A part of (D) of FIG. 7 represents a relationship between the gate voltage VG [V] (horizontal axis) of the single electronic element (SET) in a linear region under conditions different from those of in the part of (C) of FIG. 7 and the potential Vout [V] (vertical axis) of an amplified output terminal. In FIG. 7, ΔVout indicates an increase in the potential Vout due to the amplification. In FIG. 5, one MOS transistor is connected to the single electronic element, but similarly, even in a case where two MOS transistors are connected to the single electronic element, the first amplification operation can be performed by controlling the operation region of the two MOS transistors. Further, in this example, only two MOS transistors are described, but three or more MOS transistors may be coupled.

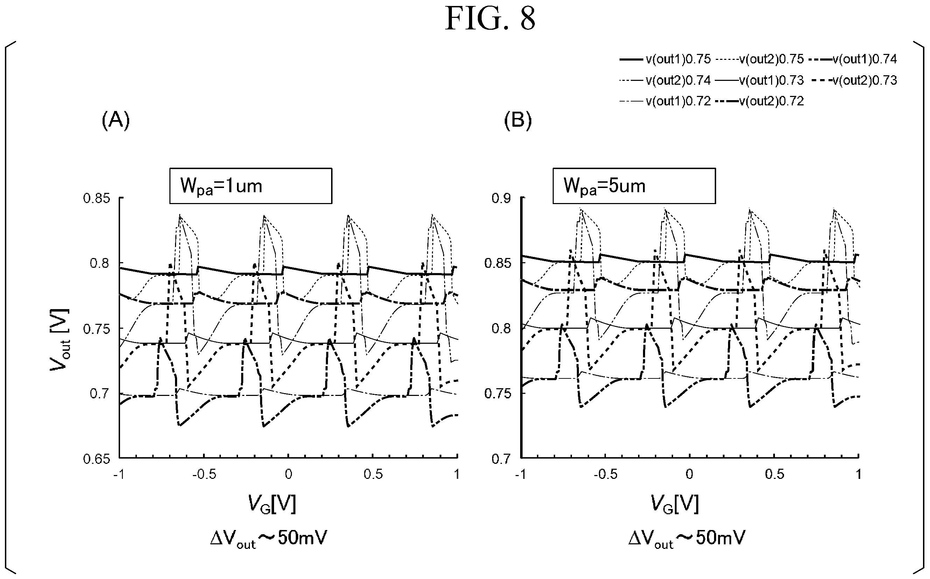

FIG. 8 is a diagram representing differential amplification simulation results obtained by a differential amplifier circuit 2E represented in FIG. 6. Specifically, a part of (A) of FIG. 8 represents a relationship between the gate voltage VG [V] (horizontal axis) of the single electronic elements 2A and 2B under a predetermined condition and the potential Vout [V] (vertical axis) of a first output terminal and a second output terminal. Here, the potential Vout[V] represents the potential of the first output terminal Vout1 and the potential of the second output terminal Vout2 in FIG. 6 together, and it can be seen that by changing the gate voltage VG [V], the difference between the potential of the first output terminal Vout1 and the potential of the second output terminal Vout2 is significant. A part of (B) of FIG. 8 represents a relationship between the gate voltage VG [V] (horizontal axis) of the single electronic elements 2A and 2B under conditions different from those of the part of (A) of FIG. 8 and the potential Vout [V] (vertical axis) of a first output terminal and a second output terminal.

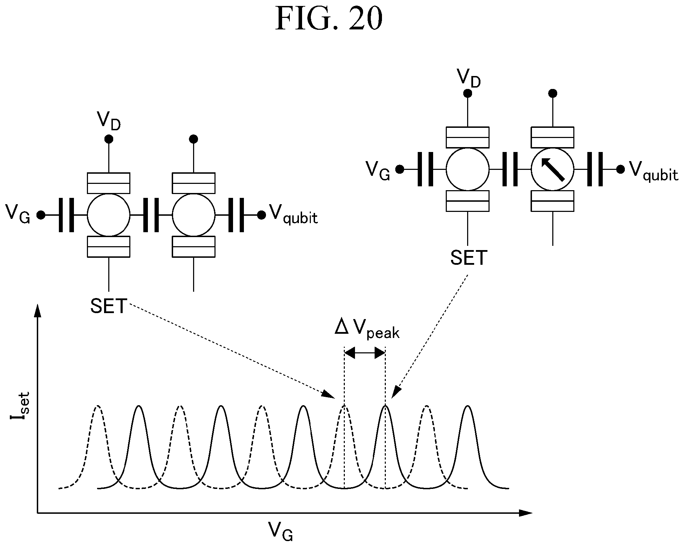

In the case of the spin quantum dot, the gate voltage VG [V] represented here simulates a situation in which the potential inside the single electronic element is shifted depending on the presence or absence of electrons in the quantum dot connected to the single electronic element as represented in FIG. 20.

### Third Embodiment

Hereinafter, the third embodiment of the quantum device, the quantum bit readout device, and the electronic circuit of the present invention will be described.

The quantum device 1 and the quantum bit readout device 2 of the third embodiment are configured in the same manner as the quantum device 1 and the quantum bit readout device 2 of the first embodiment described above, except for points described below. Therefore, according to the quantum device 1 and the quantum bit readout device 2 of the third embodiment, the same effects as those of the quantum device 1 and the quantum bit readout device 2 of the first embodiment described above can be obtained, except for the points described below.

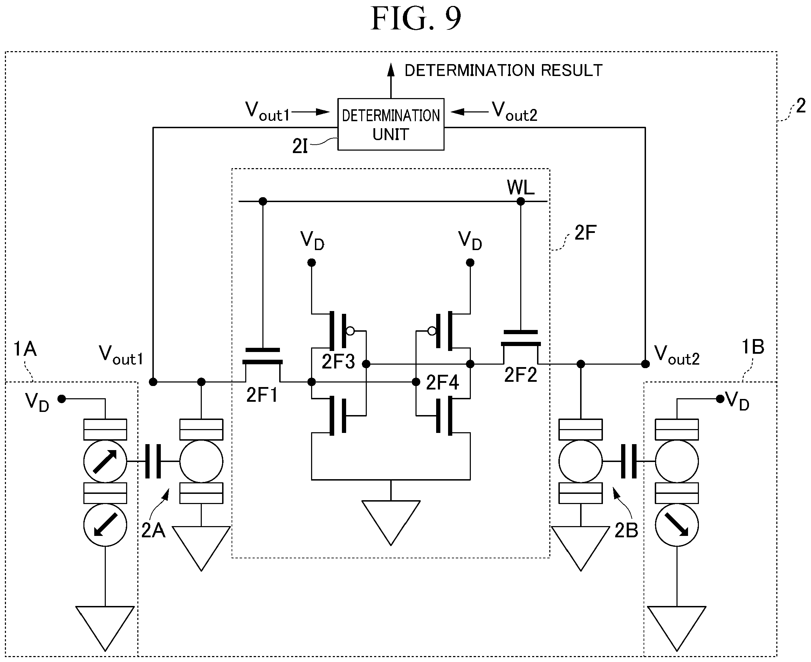

FIG. 9 is a diagram representing an example of the quantum bit readout device 2 or the like of the third embodiment. The latch circuit 1C and the determination unit 1D of the quantum device 1 of the third embodiment can be expressed as, for example, the quantum bit readout device 2 represented in FIG. 9. FIG. 9 represents a case where the quantum bit is a spin quantum bit. In a case where the quantum bit is a charge quantum bit, the single electronic element is treated as the charge quantum bit as it is.

In the example represented in FIG. 9, the quantum bit readout device 2 includes the single electronic element 2A, the single electronic element 2B, a static random access memory (SRAM) 2F, and the determination unit 2I. The SRAM 2F includes access transistors 2F1 and 2F2 and inverters 2F3 and 2F4. The inverter 2F3 and the inverter 2F4 are cross-coupled. The inverter 2F3 is configured by a P-channel MOS transistor and an N-channel MOS transistor. The inverter 2F4 is configured by a P-channel MOS transistor and an N-channel MOS transistor. In the following, the number of transistors configuring the SRAM is six, but the SRAMs composed of eight, nine, ten, or more transistors can also be used as the quantum bit readout device.

The single electronic element 2A measures a state of the spin quantum bit of the quantum circuit 1A. The gate of the single electronic element 2A is connected to the quantum circuit 1A. One of the source and the drain of the single electronic element 2A is connected to the first output terminal Vout1 of the SRAM 2F. The other of the source and the drain of the single electronic element 2A is, for example, grounded.

The single electronic element 2B measures the state of the spin quantum bit of the quantum circuit 1B. The gate of the single electronic element 2B is connected to the quantum circuit 1B. One of the source and the drain of the single electronic element 2B is connected to the second output terminal Vout2 of the SRAM 2F. The other of the source and the drain of the single electronic element 2B is, for example, grounded.

The gate of the access transistor 2F1 is connected to the word line WL. One of the source and the drain of the access transistor 2F1 is connected to the first output terminal Vout1 of the SRAM 2F. The other of the source and the drain of the access transistor 2F1 is connected to one of the source and the drain of the P-channel MOS transistor of the inverter 2F3, one of the source and the drain of the N-channel MOS transistor of the inverter 2F3, a gate of the P-channel MOS transistor of the inverter 2F4, and a gate of the N-channel MOS transistor of the inverter 2F4.

The other of the source and the drain of the P-channel MOS transistor of the inverter 2F3 is connected to the predetermined potential VD. The other of the source and the drain of the N-channel MOS transistor of the inverter 2F3 is, for example, grounded.

The gate of the access transistor 2F2 is connected to the word line WL. One of the source and the drain of the access transistor 2F2 is connected to the second output terminal Vout2 of the SRAM 2F. The other of the source and the drain of the access transistor 2F2 is connected to one of the source and the drain of the P-channel MOS transistor of the inverter 2F4, one of the source and the drain of the N-channel MOS transistor of the inverter 2F4, a gate of the P-channel MOS transistor of the inverter 2F3, and a gate of the N-channel MOS transistor of the inverter 2F3.

The other of the source and the drain of the P-channel MOS transistor of the inverter 2F4 is connected to the predetermined potential VD. The other of the source and the drain of the N-channel MOS transistor of the inverter 2F4 is, for example, grounded.

The first output terminal Vout1 and the second output terminal Vout2 of the SRAM 2F are connected to the determination unit 2I.

The determination unit 2I reads a difference between the potential (the potential at the first output terminal Vout1 of the SRAM 2F) of the single electronic element 2A amplified by the SRAM 2F (that is, output via the SRAM 2F), and the potential (the potential at the second output terminal Vout2 of the SRAM 2F) of the single electronic element 2B amplified by the SRAM 2F (that is, output via the SRAM 2F).

Specifically, the first output terminal Vout1 and the second output terminal Vout2 of the SRAM 2F output the potential of the single electronic element 2A amplified by the SRAM 2F and the potential of the single electronic element 2B amplified by the SRAM 2F as, for example, inverted results such as "0" and " 1". Further, the determination unit 2I performs determination between "0" and " 1", which is easy to handle in the subsequent digital circuit, by comparing the potential of the single electronic element 2A amplified by the SRAM 2F with the potential of the single electronic element 2B amplified by the SRAM 2F.

In the example represented in FIG. 9, the determination unit 2I can read out the states of the quantum bits of the quantum circuits 1A and 1B connected to the single electronic elements 2A and 2B while the entire circuit is minimized, by reading the difference between the potential of the single electronic element 2A amplified by the SRAM 2F and the potential of the single electronic element 2B amplified by the SRAM 2F.

In other words, in the third embodiment, the signal (specifically, the potential of the first output terminal Vout1 of the SRAM 2F) obtained by amplifying the signal indicating the state of the (spin) quantum bit output from the quantum circuit 1A by the latch circuit 1C (specifically, the SRAM 2F), is compared with the signal (specifically, the potential of the second output terminal Vout2 of the SRAM 2F) obtained by amplifying the signal indicating the state of the (spin) quantum bit output from the quantum circuit 1B by the latch circuit 1C (specifically, the SRAM 2F), so that it is possible to accurately determine the difference between the state of the (spin) quantum bit of the quantum circuit 1A and the state of the (spin) quantum bit of the quantum circuit 1B. Specifically, by inputting the input signal of the quantum circuit 1A to the input signal of the quantum circuit 1B through, for example, an inverter such that the output of the quantum circuit 1A and the output of the quantum circuit 1B are inverted between 0 and 1 through the determination unit 2I, it is possible to improve the accuracy rate of readout of the state of the quantum bit.

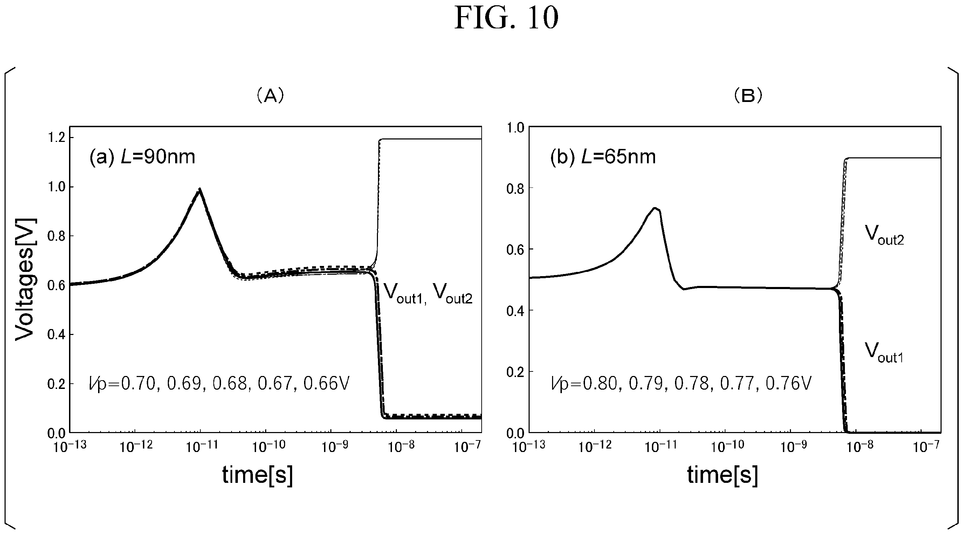

FIG. 10 is a diagram representing results of circuit simulation (time change) represented in FIG. 9. Specifically, FIG. 10A represents time waveforms (not separated by time) of the potential of the first output terminal Vout1 and the potential of a second output terminal Vout2 of the SRAM 2F under a predetermined condition of a gate length of 90 nm, and time waveforms (separated by time) of the potential of the first output terminal Vout1 and the potential of the second output terminal Vout2 of the SRAM 2F under a condition different from the condition. FIG. 10B represents time waveforms (not separated by time) of the potential of the first output terminal Vout1 and the potential of a second output terminal Vout2 of the SRAM 2F under a condition different from that of FIG. 10A with a gate length of 65 nm, and time waveforms (separated by time) of the potential of the first output terminal Vout1 and the potential of the second output terminal Vout2 of the SRAM 2F under a condition different from the condition.

### Fourth Embodiment

Hereinafter, the fourth embodiment of the quantum device, the quantum bit readout device, and the electronic circuit of the present invention will be described.

The quantum device 1 and the quantum bit readout device 2 of the fourth embodiment are configured in the same manner as the quantum device 1 and the quantum bit readout device 2 of the third embodiment described above, except for points described below. Therefore, according to the quantum device 1 and the quantum bit readout device 2 of the fourth embodiment, the same effects as those of the quantum device 1 and the quantum bit readout device 2 of the third embodiment described above can be obtained, except for the points described below.

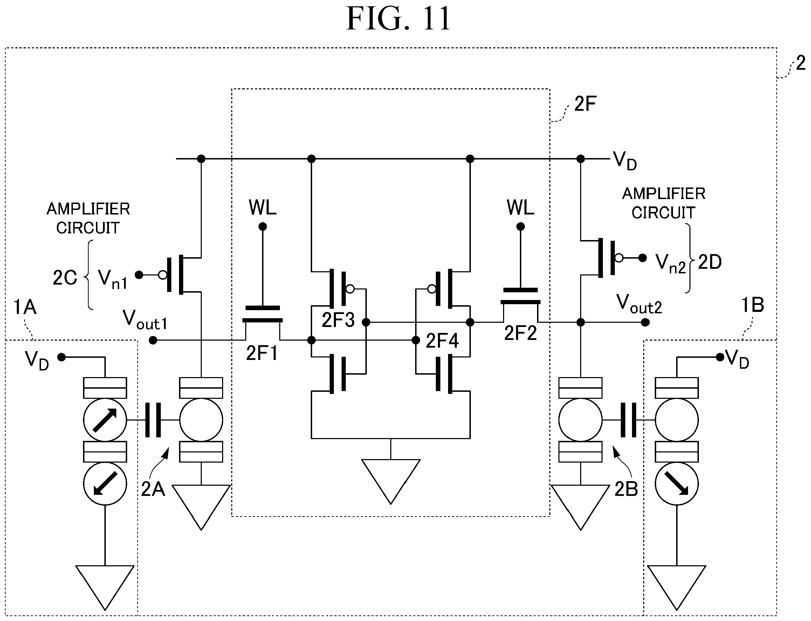

FIG. 11 is a diagram representing an example of the quantum bit readout device 2 or the like of the fourth embodiment. The latch circuit 1C and the determination unit 1D of the quantum device 1 of the fourth embodiment can be expressed as, for example, the quantum bit readout device 2 represented in FIG. 11. FIG. 11 represents a case where the quantum bit is a spin quantum bit. In a case where the quantum bit is a charge quantum bit, the single electronic element is treated as the charge quantum bit as it is.

In the example represented in FIG. 11, the quantum bit readout device 2 includes the single electronic element 2A, the single electronic element 2B, the amplifier circuit 2C, the amplifier circuit 2D, the SRAM 2F, and the determination unit 2I (see FIG. 9). The amplifier circuit 2C is configured by a P-channel MOS transistor. The amplifier circuit 2D is configured by a P-channel MOS transistor. The SRAM 2F includes access transistors 2F1 and 2F2 and inverters 2F3 and 2F4. The inverter 2F3 and the inverter 2F4 are cross-coupled. The inverter 2F3 is configured by a P-channel MOS transistor and an N-channel MOS transistor. The inverter 2F4 is configured by a P-channel MOS transistor and an N-channel MOS transistor.

The single electronic element 2A measures a state of the spin quantum bit of the quantum circuit 1A. The gate of the single electronic element 2A is connected to the quantum circuit 1A. One of the source and the drain of the single electronic element 2A is connected to the first output terminal Vout1 of the SRAM 2F. The other of the source and the drain of the single electronic element 2A is, for example, grounded.

The single electronic element 2B measures the state of the spin quantum bit of the quantum circuit 1B. The gate of the single electronic element 2B is connected to the quantum circuit 1B. One of the source and the drain of the single electronic element 2B is connected to the second output terminal Vout2 of the SRAM 2F. The other of the source and the drain of the single electronic element 2B is, for example, grounded.

One of the source and the drain of the P-channel MOS transistor that functions as the amplifier circuit 2C is connected to the first output terminal Vout1 of the SRAM 2F. The other of the source and the drain of the P-channel MOS transistor that functions as the amplifier circuit 2C is connected to a predetermined potential VD. That is, the amplifier circuit 2C is disposed between the single electronic element 2A and the SRAM 2F.

One of the source and the drain of the P-channel MOS transistor functions as the amplifier circuit 2D is connected to the second output terminal Vout2 of the SRAM 2F. The other of the source and the drain of the P-channel MOS transistor that functions as the amplifier circuit 2D is connected to the predetermined potential VD. That is, the amplifier circuit 2D is disposed between the single electronic element 2B and the SRAM 2F.

The access transistors 2F1 and 2F2, and the inverters 2F3 and 2F4 of the SRAM 2F are connected in the same manner as the access transistors 2F1 and 2F2 and the inverters 2F3 and 2F4 of the SRAM 2F represented in FIG. 9.

The first output terminal Vout1 and the second output terminal Vout2 of the SRAM 2F are connected to the determination unit 2I.

The determination unit 2I reads a difference between the potential (the potential at the first output terminal Vout1 of the SRAM 2F) of the single electronic element 2A amplified by the amplifier circuit 2C and the SRAM 2F (that is, output via the SRAM 2F), and the potential (the potential at the second output terminal Vout2 of the SRAM 2F) of the single electronic element 2B amplified by the amplifier circuit 2D and the SRAM 2F (that is, output via the SRAM 2F).

Specifically, the first output terminal Vout1 and the second output terminal Vout2 of the SRAM 2F output the potential difference between the potential of the single electronic element 2A amplified by the amplifier circuit 2C and the SRAM 2F and the potential of the single electronic element 2B amplified by the amplifier circuit 2D and the SRAM 2F as a larger value compared to the potential difference originally between the output terminal of the single electronic element 2A and the output terminal of the single electronic element 2B. Further, the determination unit 2I performs determination between "0" and "1", by comparing the potential of the single electronic element 2A amplified by the amplifier circuit 2C and the SRAM 2F with the potential of the single electronic element 2B amplified by the amplifier circuit 2D and the SRAM 2F.

In the example represented in FIG. 11, the determination unit 2I can read out the states of the quantum bits of the quantum circuits 1A and 1B connected to the single electronic elements 2A and 2B while the entire circuit is minimized, by reading the difference between the potential of the single electronic element 2A amplified by the amplifier circuit 2C and the SRAM 2F and the potential of the single electronic element 2B amplified by the amplifier circuit 2D and the SRAM 2F.

In other words, in the fourth embodiment, the signal (specifically, the potential of the first output terminal Vout1 of the SRAM 2F) obtained by amplifying the signal indicating the state of the (spin) quantum bit output from the quantum circuit 1A by the latch circuit 1C (specifically, the amplifier circuit 2C and the SRAM 2F), is compared with the signal (specifically, the potential of the second output terminal Vout2 of the SRAM 2F) obtained by amplifying the signal indicating the state of the spin quantum bit output from the quantum circuit 1B by the latch circuit 1C (specifically, the amplifier circuit 2D and the SRAM 2F), so that it is possible to accurately determine the difference between the state of the (spin) quantum bit of the quantum circuit 1A and the state of the (spin) quantum bit of the quantum circuit 1B. Specifically, by inputting the input signal of the quantum circuit 1A to the input signal of the quantum circuit 1B through, for example, an inverter such that the output of the quantum circuit 1A and the output of the quantum circuit 1B are inverted between 0 and 1 through the determination unit 2I, it is possible to improve the accuracy rate of readout of the state of the quantum bit.

### Fifth Embodiment

Hereinafter, the fifth embodiment of the quantum device, the quantum bit readout device, and the electronic circuit of the present invention will be described.

The quantum device 1 and the quantum bit readout device 2 of the fifth embodiment are configured in the same manner as the quantum device 1 and the quantum bit readout device 2 of the first embodiment described above, except for points described below. Therefore, according to the quantum device 1 and the quantum bit readout device 2 of the fifth embodiment, the same effects as those of the quantum device 1 and the quantum bit readout device 2 of the first embodiment described above can be obtained, except for the points described below.

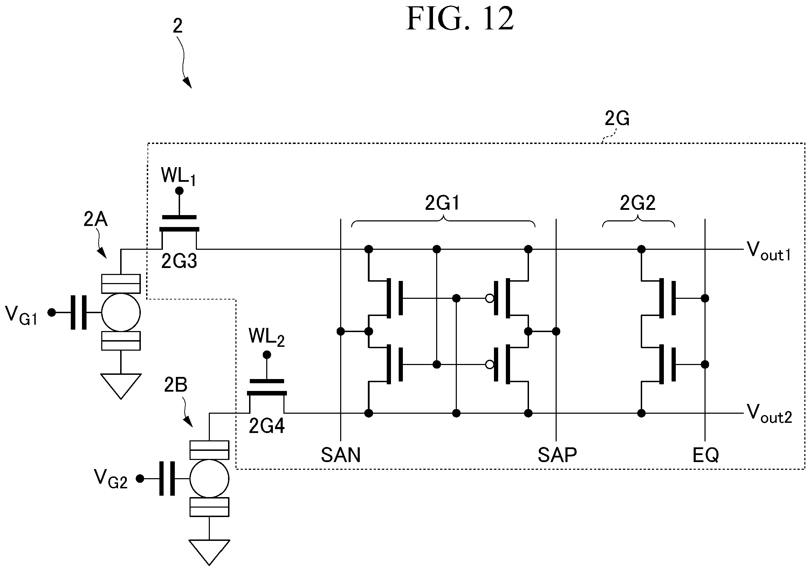

FIG. 12 is a diagram representing an example of the quantum bit readout device 2 of the fifth embodiment. The latch circuit 1C and the determination unit 1D of the quantum device 1 of the fifth embodiment can be expressed as, for example, the quantum bit readout device 2 represented in FIG. 12.

In the example represented in FIG. 12, the quantum bit readout device 2 includes a sense amplifier 2G1, an equalizer 2G2, transistors 2G3 and 2G4, and the determination unit 2I (see FIG. 6). The sense amplifier 2G1 is configured by a first P-channel MOS transistor, a second P-channel MOS transistor, a first N-channel MOS transistor, and a second N-channel MOS transistor that function as an amplifier circuit. The equalizer 2G2 is configured by a first N-channel MOS transistor and a second N-channel MOS transistor of which the gates receive input with a common equalization signal EQ.

The single electronic element 2A measures the state of the spin quantum bit of the quantum circuit 1A (not represented in FIG. 12). The single electronic element 2A is included in the quantum circuit 1A. One of the source and the drain of the single electronic element 2A is connected to one of the source and the drain of the transistor 2G3. The other of the source and the drain of the single electronic element 2A is, for example, grounded.

The single electronic element 2B measures the state of the spin quantum bit of the quantum circuit 1B (not represented in FIG. 12). The single electronic element 2B is included in the quantum circuit 1B. One of the source and the drain of the single electronic element 2B is connected to one of the source and the drain of the transistor 2G4. The other of the source and the drain of the single electronic element 2B is, for example, grounded.

The other of the source and the drain of the transistor 2G3 is connected to the first output terminal Vout1 of the amplifier circuit 2G. A wiring connecting the other of the source and the drain of the transistor 2G3 to the first output terminal Vout1 of the amplifier circuit 2G functions as a first bit line. The gate of the transistor 2G3 is connected to a word line WL1.

The other of the source and the drain of the transistor 2G4 is connected to the second output terminal Vout2 of the amplifier circuit 2G. A wiring connecting the other of the source and the drain of the transistor 2G4 to the second output terminal Vout2 of the amplifier circuit 2G functions as a second bit line. The gate of the transistor 2G4 is connected to a word line WL2.

The first bit line connecting the other of the source and the drain of the transistor 2G3 to the first output terminal Vout1 of the amplifier circuit 2G is connected to the gate of the first P-channel MOS transistor of the sense amplifier 2G1 and the gate of the first N-channel MOS transistor of the sense amplifier 2G1.

The second bit line connecting the other of the source and the drain of the transistor 2G4 to the second output terminal Vout2 of the amplifier circuit 2G is connected to the gate of the second P-channel MOS transistor of the sense amplifier 2G1 and the gate of the second N-channel MOS transistor of the sense amplifier 2G1.

One of the source and the drain of the first P-channel MOS transistor of the sense amplifier 2G1 is connected to the second bit line. One of the source and the drain of the second P-channel MOS transistor of the sense amplifier 2G1 is connected to the first bit line. A common sense amplifier activation signal SAP is input to the other of the source and the drain of the first P-channel MOS transistor of the sense amplifier 2G1 and the other of the source and the drain of the second P-channel MOS transistor of the sense amplifier 2G1.

One of the source and the drain of the first N-channel MOS transistor of the sense amplifier 2G1 is connected to the second bit line. One of the source and the drain of the second N-channel MOS transistor of the sense amplifier 2G1 is connected to the first bit line. A common sense amplifier activation signal SAN is input to the other of the source and the drain of the first N-channel MOS transistor of the sense amplifier 2G1 and the other of the source and the drain of the second N-channel MOS transistor of the sense amplifier 2G1.

One of the source and the drain of the first N-channel MOS transistor of the equalizer 2G2 is connected to the first bit line. One of the source and the drain of the second N-channel MOS transistor of the equalizer 2G2 is connected to the second bit line. The other of the source and the drain of the first N-channel MOS transistor of the equalizer 2G2 is connected to the other of the source and the drain of the second N-channel MOS transistor of the equalizer 2G2.

The first output terminal Vout1 and the second output terminal Vout2 of the amplifier circuit 2G are connected to the determination unit 2I.

The determination unit 2I reads a difference between the potential (the potential at the first output terminal Vout1 of the amplifier circuit 2G) of the single electronic element 2A amplified by the amplifier circuit 2G (that is, output via the amplifier circuit 2G), and the potential (the potential at the second output terminal Vout2 of the amplifier circuit 2G) of the single electronic element 2B amplified by the amplifier circuit 2G (that is, output via the amplifier circuit 2G).

Specifically, the first output terminal Vout1 and the second output terminal Vout2 of the amplifier circuit 2G output the potential difference between the potential of the single electronic element 2A amplified by the amplifier circuit 2G and the potential of the single electronic element 2B amplified by the amplifier circuit 2G as a larger value compared to the potential difference originally between the output terminal of the single electronic element 2A and the output terminal of the single electronic element 2B. Further, the determination unit 2I performs determination between "0" and " 1", by comparing the potential of the single electronic element 2A amplified by the amplifier circuit 2G with the potential of the single electronic element 2B amplified by the amplifier circuit 2G.

In the example represented in FIG. 12, the determination unit 2I can read out the states of the quantum bits of the quantum circuits 1A and 1B connected to the single electronic elements 2A and 2B while the entire circuit is minimized, by reading the difference between the potential of the single electronic element 2A amplified by the amplifier circuit 2G and the potential of the single electronic element 2B amplified by the amplifier circuit 2G.

In other words, in the fifth embodiment, the signal (specifically, the potential of the first output terminal Vout1 of the amplifier circuit 2G) obtained by amplifying the signal indicating the state of the (spin) quantum bit output from the quantum circuit 1A by the latch circuit 1C (specifically, the amplifier circuit 2G), is compared with the signal (specifically, the potential of the second output terminal Vout2 of the amplifier circuit 2G) obtained by amplifying the signal indicating the state of the (spin) quantum bit output from the quantum circuit 1B by the latch circuit 1C (specifically, the amplifier circuit 2G), so that it is possible to accurately determine the difference between the state of the (spin) quantum bit of the quantum circuit 1A and the state of the (spin) quantum bit of the quantum circuit 1B. Specifically, by inputting the input signal of the quantum circuit 1A to the input signal of the quantum circuit 1B through, for example, an inverter such that the output of the quantum circuit 1A and the output of the quantum circuit 1B are inverted between 0 and 1 through the determination unit 2I, it is possible to improve the accuracy rate of readout of the state of the quantum bit.

### Sixth Embodiment

Hereinafter, the sixth embodiment of the quantum device, the quantum bit readout device, and the electronic circuit of the present invention will be described.

The quantum device 1 and the quantum bit readout device 2 of the sixth embodiment are configured in the same manner as the quantum device 1 and the quantum bit readout device 2 of the fifth embodiment described above, except for points described below. Therefore, according to the quantum device 1 and the quantum bit readout device 2 of the sixth embodiment, the same effects as those of the quantum device 1 and the quantum bit readout device 2 of the fifth embodiment described above can be obtained, except for the points described below.

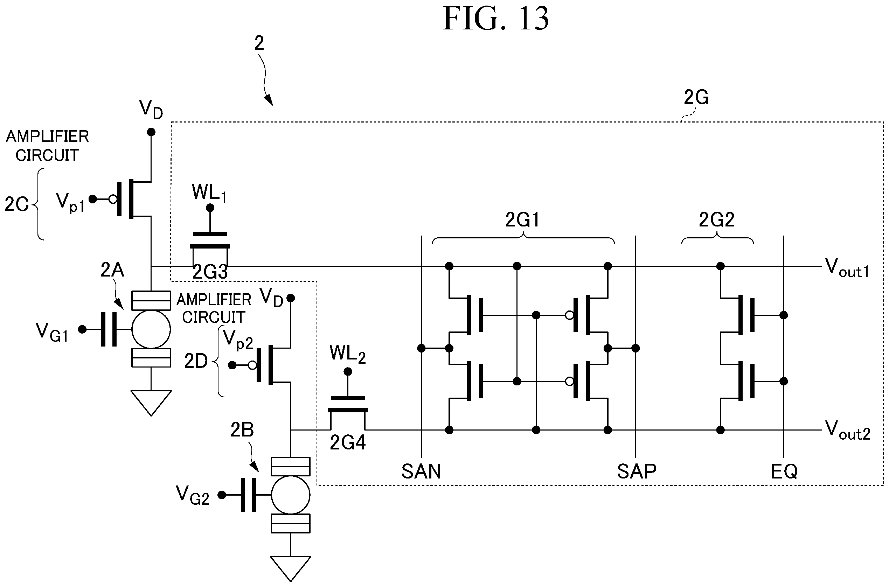

FIG. 13 is a diagram representing an example of the quantum bit readout device 2 of the sixth embodiment. The latch circuit 1C of the quantum device 1 of the sixth embodiment can be expressed as, for example, the quantum bit readout device 2 represented in FIG. 13.

In the example represented in FIG. 13, the quantum bit readout device 2 includes the single electronic element 2A, the single electronic element 2B, the amplifier circuit 2C, the amplifier circuit 2D, the amplifier circuit 2G, and the determination unit 2I (see FIG. 6). The amplifier circuit 2C is configured by a P-channel MOS transistor. The amplifier circuit 2D is configured by a P-channel MOS transistor.

Each of the amplifier circuits 2C and 2D may be configured by two or more MOS transistors as represented in FIG. 7.

The single electronic element 2A measures the state of the spin quantum bit of the quantum circuit 1A (see FIG. 2). The gate of the single electronic element 2A is connected to the quantum circuit 1A. One of the source and the drain of the single electronic element 2A is connected to one of the source and the drain of the transistor 2G3 of the amplifier circuit 2G and one of the source and the drain of the P-channel MOS transistor that functions as the amplifier circuit 2C. The other of the source and the drain of the single electronic element 2A is, for example, grounded. The other of the source and the drain of the P-channel MOS transistor that functions as the amplifier circuit 2C is connected to a predetermined potential VD. That is, the amplifier circuit 2C is disposed between the single electronic element 2A and the amplifier circuit 2G.

The single electronic element 2B measures the state of the spin quantum bit of the quantum circuit 1B (see FIG. 2). The gate of the single electronic element 2B is connected to the quantum circuit 1B. One of the source and the drain of the single electronic element 2B is connected to one of the source and the drain of the transistor 2G4 of the amplifier circuit 2G and one of the source and the drain of the P-channel MOS transistor that functions as the amplifier circuit 2D. The other of the source and the drain of the single electronic element 2B is, for example, grounded. The other of the source and the drain of the P-channel MOS transistor that functions as the amplifier circuit 2D is connected to the predetermined potential VD. That is, the amplifier circuit 2D is disposed between the single electronic element 2B and the amplifier circuit 2G.

The amplifier circuit 2G is configured similarly to the amplifier circuit 2G represented in FIG. 12. That is, the first output terminal Vout1 and the second output terminal Vout2 of the SRAM 2F are connected to the determination unit 2I.

The determination unit 2I reads a difference between the potential (the potential at the first output terminal Vout1 of the amplifier circuit 2G) of the single electronic element 2A amplified by the amplifier circuit 2C and the amplifier circuit 2G (that is, output via the amplifier circuit 2G), and the potential (the potential at the second output terminal Vout2 of the amplifier circuit 2G) of the single electronic element 2B amplified by the amplifier circuit 2D and the amplifier circuit 2G (that is, output via the amplifier circuit 2G).

Specifically, the first output terminal Vout1 and the second output terminal Vout2 of the amplifier circuit 2G output the potential difference between the potential of the single electronic element 2A amplified by the amplifier circuit 2C and the amplifier circuit 2G and the potential of the single electronic element 2B amplified by the amplifier circuit 2D and the amplifier circuit 2G as a larger value compared to the potential difference originally between the output terminal of the single electronic element 2A and the output terminal of the single electronic element 2B. Further, the determination unit 2I performs determination between "0" and "1", by comparing the potential of the single electronic element 2A amplified by the amplifier circuit 2C and the amplifier circuit 2G with the potential of the single electronic element 2B amplified by the amplifier circuit 2D and the amplifier circuit 2G.

In the example represented in FIG. 13, the determination unit 2I can read out the states of the quantum bits of the quantum circuits 1A and 1B connected to the single electronic elements 2A and 2B while the entire circuit is minimized, by reading the difference between the potential of the single electronic element 2A amplified by the amplifier circuit 2C and the amplifier circuit 2G and the potential of the single electronic element 2B amplified by the amplifier circuit 2D and the amplifier circuit 2G.

In other words, in the sixth embodiment, the signal (specifically, the potential of the first output terminal Vout1 of the amplifier circuit 2G) obtained by amplifying the signal indicating the state of the (spin) quantum bit output from the quantum circuit 1A by the latch circuit 1C (specifically, the amplifier circuit 2C and the amplifier circuit 2G), is compared with the signal (specifically, the potential of the second output terminal Vout2 of the amplifier circuit 2G) obtained by amplifying the signal indicating the state of the (spin) quantum bit output from the quantum circuit 1B by the latch circuit 1C (specifically, the amplifier circuit 2D and the amplifier circuit 2G), so that it is possible to accurately determine the difference between the state of the (spin) quantum bit of the quantum circuit 1A and the state of the (spin) quantum bit of the quantum circuit 1B. Specifically, by inputting the input signal of the quantum circuit 1A to the input signal of the quantum circuit 1B through, for example, an inverter such that the output of the quantum circuit 1A and the output of the quantum circuit 1B are inverted between 0 and 1 through the determination unit 2I, it is possible to improve the accuracy rate of readout of the state of the quantum bit.

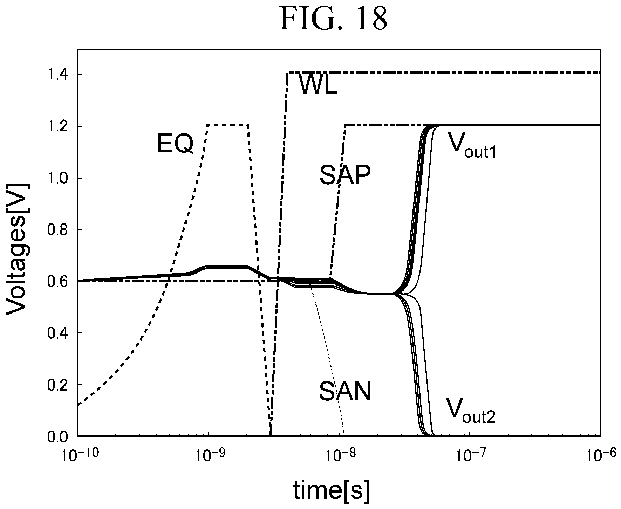

FIG. 18 is a diagram representing a time change of a voltage in the quantum bit readout device 2 of the sixth embodiment represented in FIG. 13.

As represented in FIG. 18, by temporally adjusting the input signals of the equalizer 2G2 and the sense amplifier 2G1, it is possible to clearly distinguish a potential Vout1 of the first output terminal Vout1 of the amplifier circuit 2G from a potential Vout2 of the second output terminal Vout2 of the amplifier circuit 2G.

### Seventh Embodiment

Hereinafter, the seventh embodiment of the quantum device, the quantum bit readout device, and the electronic circuit of the present invention will be described.

The quantum device 1 and the quantum bit readout device 2 of the seventh embodiment are configured in the same manner as the quantum device 1 and the quantum bit readout device 2 of the first embodiment described above, except for points described below. Therefore, according to the quantum device 1 and the quantum bit readout device 2 of the seventh embodiment, the same effects as those of the quantum device 1 and the quantum bit readout device 2 of the first embodiment described above can be obtained, except for the points described below.

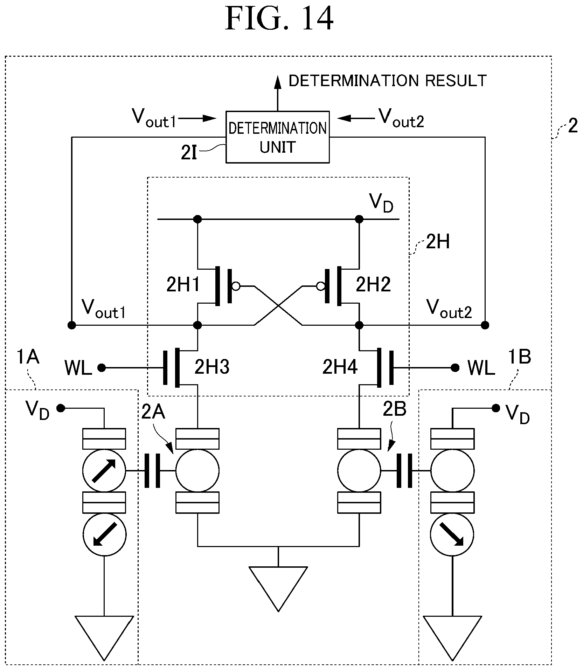

FIG. 14 is a diagram representing an example of the quantum bit readout device 2 or the like of the seventh embodiment. The latch circuit 1C and the determination unit 1D of the quantum device 1 of the seventh embodiment can be expressed as, for example, the quantum bit readout device 2 represented in FIG. 14.

FIG. 14 represents a case where the quantum bit is a spin quantum bit. In a case where the quantum bit is a charge quantum bit, the single electronic element is treated as the charge quantum bit as it is.

In the example represented in FIG. 14, the quantum bit readout device 2 includes the single electronic element 2A, the single electronic element 2B, a cross-coupled MOS transistor circuit 2H, and the determination unit 2I. The cross-coupled MOS transistor circuit 2H includes a pair of cross-coupled P-channel MOS transistors 2H1 and 2H2, and transistors 2H3 and 2H4.

The single electronic element 2A measures a state of the quantum bit of the quantum circuit 1A. The gate of the single electronic element 2A is connected to the quantum circuit 1A. One of the source and the drain of the single electronic element 2A is connected to one of the source and the drain of the transistor 2H3 of the cross-coupled MOS transistor circuit 2H. The other of the source and the drain of the single electronic element 2A is, for example, grounded.

The single electronic element 2B measures the state of the quantum bit of the quantum circuit 1B. The gate of the single electronic element 2B is connected to the quantum circuit 1B. One of the source and the drain of the single electronic element 2B is connected to one of the source and the drain of the transistor 2H4 of the cross-coupled MOS transistor circuit 2H. The other of the source and the drain of the single electronic element 2B is, for example, grounded.

The other of the source and the drain of the transistor 2H3 is connected to the first output terminal Vout1 of the cross-coupled MOS transistor circuit 2H. The gate of the transistor 2H3 is connected to the word line WL.

The other of the source and the drain of the transistor 2H4 is connected to the second output terminal Vout2 of the cross-coupled MOS transistor circuit 2H. The gate of the transistor 2H4 is connected to the word line WL.

One of the source and the drain of the P-channel MOS transistor 2H1 and the gate of the P-channel MOS transistor 2H2 are connected to the first output terminal Vout1 of the cross-coupled MOS transistor circuit 2H. The other of the source and the drain of the P-channel MOS transistor 2H1 is connected to the predetermined potential VD.

One of the source and the drain of the P-channel MOS transistor 2H2 and the gate of the P-channel MOS transistor 2H1 are connected to the second output terminal Vout2 of the cross-coupled MOS transistor circuit 2H. The other of the source and the drain of the P-channel MOS transistor 2H2 is connected to the predetermined potential VD.

The first output terminal Vout1 and the second output terminal Vout2 of the cross-coupled MOS transistor circuit 2H are connected to the determination unit 2I.

The determination unit 2I reads the difference between the potential (the potential at the first output terminal Vout1 of the cross-coupled MOS transistor circuit 2H) of the single electronic element 2A amplified by the cross-coupled MOS transistor circuit 2H (that is, output via the cross-coupled MOS transistor circuit 2H), and the potential (the potential at the second output terminal Vout2 of the cross-coupled MOS transistor circuit 2H) of the single electronic element 2B amplified by the cross-coupled MOS transistor circuit 2H (that is, output via the cross-coupled MOS transistor circuit 2H).

Specifically, the first output terminal Vout1 and the second output terminal Vout2 of the cross-coupled MOS transistor circuit 2H output the potential difference between the potential of the single electronic element 2A amplified by the cross-coupled MOS transistor circuit 2H and the potential of the single electronic element 2B amplified by the cross-coupled MOS transistor circuit 2H as a larger value compared to the potential difference originally between the output terminal of the single electronic element 2A and the output terminal of the single electronic element 2B. Further, the determination unit 2I performs determination between "0" and "1", by comparing the potential of the single electronic element 2A amplified by the cross-coupled MOS transistor circuit 2H with the potential of the single electronic element 2B amplified by the cross-coupled MOS transistor circuit 2H.

In the example represented in FIG. 14, the determination unit 2I can read out the states of the quantum bits of the quantum circuits 1A and 1B connected to the single electronic elements 2A and 2B while the entire circuit is minimized, by reading the difference between the potential of the single electronic element 2A amplified by the cross-coupled MOS transistor circuit 2H and the potential of the single electronic element 2B amplified by the cross-coupled MOS transistor circuit 2H.

In other words, in the seventh embodiment, the signal (specifically, the potential of the first output terminal Vout1 of the cross-coupled MOS transistor circuit 2H) obtained by amplifying the signal indicating the state of the (spin) quantum bit output from the quantum circuit 1A by the latch circuit 1C (specifically, the cross-coupled MOS transistor circuit 2H), is compared with the signal (specifically, the potential of the second output terminal Vout2 of the cross-coupled MOS transistor circuit 2H) obtained by amplifying the signal indicating the state of the (spin) quantum bit output from the quantum circuit 1B by the latch circuit 1C (specifically, the cross-coupled MOS transistor circuit 2H), so that it is possible to accurately determine the difference between the state of the (spin) quantum bit of the quantum circuit 1A and the state of the (spin) quantum bit of the quantum circuit 1B. Specifically, by inputting the input signal of the quantum circuit 1A to the input signal of the quantum circuit 1B through, for example, an inverter, it is possible to improve the accuracy rate of readout of the state of the quantum bit.

Although a pair of P-channel MOS transistors is used in FIG. 14, an N-channel MOS transistor may be used, and another single electronic element or one or more N-channel MOS transistors may be added without grounding one end of the single electronic element. In general, each of the P-channel MOS transistors and the N-channel MOS transistors may be connected in series or in parallel to one or more single electronic elements.

### Eighth Embodiment

Hereinafter, the eighth embodiment of the quantum device, the quantum bit readout device, and the electronic circuit of the present invention will be described.

The quantum device 1 and the quantum bit readout device 2 of the eighth embodiment are configured in the same manner as the quantum device 1 and the quantum bit readout device 2 of the first embodiment described above, except for points described below. Therefore, according to the quantum device 1 and the quantum bit readout device 2 of the eighth embodiment, the same effects as those of the quantum device 1 and the quantum bit readout device 2 of the first embodiment described above can be obtained, except for the points described below.

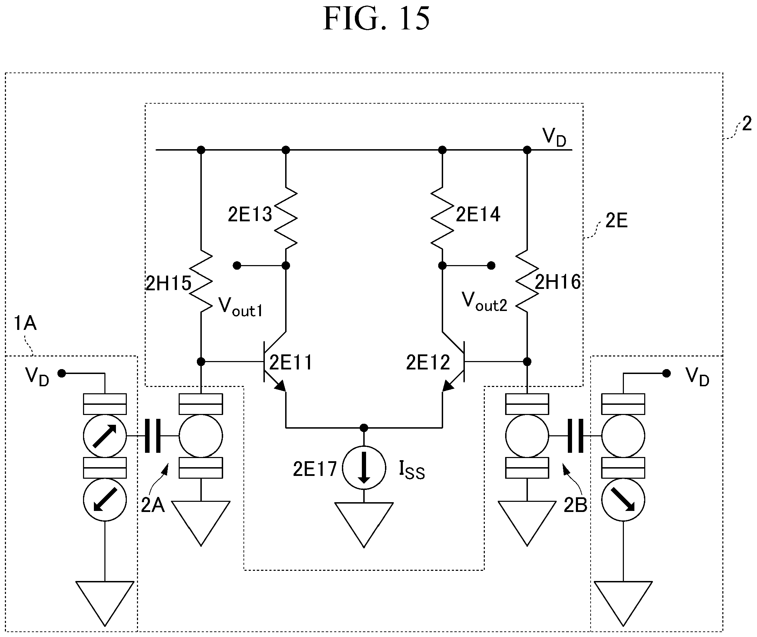

FIG. 15 is a diagram representing an example of the quantum bit readout device 2 or the like of the eighth embodiment. The latch circuit 1C and the determination unit 1D of the quantum device 1 of the eighth embodiment can be expressed as, for example, the quantum bit readout device 2 represented in FIG. 15. FIG. 15 represents a case where the quantum bit is a spin quantum bit. In a case where the quantum bit is a charge quantum bit, the single electronic element is treated as the charge quantum bit as it is.

In the example represented in FIG. 15, the quantum bit readout device 2 includes the differential amplifier circuit 2E and the determination unit 2I (see FIG. 2). The differential amplifier circuit 2E includes bipolar transistors 2E11 and 2E12, resistors 2E13, 2E14, 2E15, and 2E16, and a constant current source 2E17.

The single electronic element 2A measures a state of the quantum bit of the quantum circuit 1A. The single electronic element 2A is included in the quantum circuit 1A. One of the source and the drain of the single electronic element 2A is connected to the base of the bipolar transistor 2E11 and is connected to the predetermined potential VD via the resistor 2E15. The other of the source and the drain of the single electronic element 2A is, for example, grounded.

The single electronic element 2B measures the state of the quantum bit of the quantum circuit 1B. The single electronic element 2B is included in the quantum circuit 1B. One of the source and the drain of the single electronic element 2B is connected to the base of the bipolar transistor 2E12 and is connected to the predetermined potential VD via the resistor 2E16. The other of the source and the drain of the single electronic element 2B is, for example, grounded.

The emitter of the bipolar transistor 2E11 is connected to the constant current source 2E17. The collector of the bipolar transistor 2E11 is connected to the first output terminal Vout1 of the differential amplifier circuit 2E. The first output terminal Vout1 of the differential amplifier circuit 2E is connected to the predetermined potential VD via the resistor 2E13.

The emitter of the bipolar transistor 2E12 is connected to the constant current source 2E17. The collector of the bipolar transistor 2E12 is connected to the second output terminal Vout2 of the differential amplifier circuit 2E. The second output terminal Vout2 of the differential amplifier circuit 2E is connected to the predetermined potential VD via the resistor 2E14.

The first output terminal Vout1 and the second output terminal Vout2 of the differential amplifier circuit 2E are connected to the determination unit 2I.

The determination unit 2I reads a difference between the potential (the potential at the first output terminal of the differential amplifier circuit 2E) of the single electronic element 2A amplified by the differential amplifier circuit 2E, and the potential (the potential at the second output terminal of the differential amplifier circuit 2E) of the single electronic element 2B amplified by the differential amplifier circuit 2E.

Specifically, the first output terminal Vout1 and the second output terminal Vout2 of the differential amplifier circuit 2E amplify the potential difference between the potential of the single electronic element 2A amplified by the differential amplifier circuit 2E and the potential of the single electronic element 2B amplified by the differential amplifier circuit 2E. Further, the determination unit 2I performs determination between "0" and "1", by comparing the potential of the single electronic element 2A amplified by the differential amplifier circuit 2E with the potential of the single electronic element 2B amplified by differential amplifier circuit 2E.

In the example represented in FIG. 15, the determination unit 2I can read out the states of the quantum bits of the quantum circuits 1A and 1B connected to the single electronic elements 2A and 2B while the entire circuit is minimized, by reading the difference between the potential of the single electronic element 2A amplified by the differential amplifier circuit 2E and the potential of the single electronic element 2B amplified by the differential amplifier circuit 2E.

In other words, in the eighth embodiment, the signal (specifically, the potential of the first output terminal Vout1 of the differential amplifier circuit 2E) obtained by amplifying the signal indicating the state of the quantum bit output from the quantum circuit 1A by the latch circuit 1C (specifically, the differential amplifier circuit 2E), is compared with the signal (specifically, the potential of the second output terminal Vout2 of the differential amplifier circuit 2E) obtained by amplifying the signal indicating the state of the quantum bit output from the quantum circuit 1B by the latch circuit 1C (specifically, the differential amplifier circuit 2E), so that it is possible to accurately determine the difference between the state of the quantum bit of the quantum circuit 1A and the state of the quantum bit of the quantum circuit 1B. Specifically, by inputting the input signal of the quantum circuit 1A to the input signal of the quantum circuit 1B through, for example, an inverter such that the output of the quantum circuit 1A and the output of the quantum circuit 1B are inverted between 0 and 1 through the determination unit 2I, it is possible to improve the accuracy rate of readout of the state of the quantum bit.

### Ninth Embodiment

Hereinafter, the ninth embodiment of the quantum device, the quantum bit readout device, and the electronic circuit of the present invention will be described.

The electronic circuit 3 of the ninth embodiment is configured in the same manner as the quantum bit readout device 2 of the above-described seventh embodiment, except for points described below. Therefore, according to the electronic circuit 3 of the ninth embodiment, the same effects as those of the quantum bit readout device 2 of the above-described seventh embodiment can be obtained, except for the points described below.

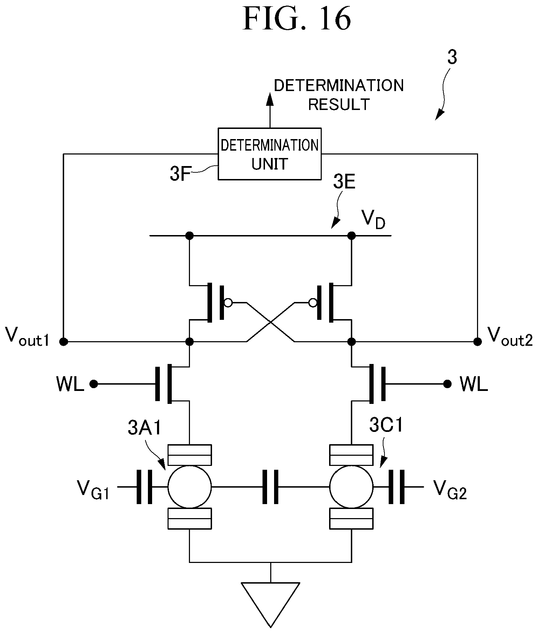

FIG. 16 is a diagram representing an example of the electronic circuit 3 of the ninth embodiment.

In the example represented in FIG. 16, the electronic circuit 3 includes the first single electronic element array 3A (see FIG. 17), a first selector 3B (see FIG. 17), the second single electronic element array 3C (see FIG. 17), a second selector 3D (see FIG. 17), an amplifier circuit 3E, and a determination unit 3F.

The first single electronic element array 3A includes a plurality of single electronic elements. The first selector 3B selects a first single electronic element 3A1, which is one single electronic element, from the plurality of single electronic elements included in the first single electronic element array 3A.

The second single electronic element array 3C includes a plurality of single electronic elements. The second selector 3D selects a second single electronic element 3C1, which is one single electronic element, from the plurality of single electronic elements included in the second single electronic element array 3C.

The amplifier circuit 3E is configured similarly to the cross-coupled MOS transistor circuit 2H represented in FIG. 14. The amplifier circuit 3E amplifies the potential of the first single electronic element 3A1 selected by the first selector 3B and the potential of the second single electronic element 3C1 selected by the second selector 3D.

The determination unit 3F functions in the same manner as the determination unit 2I represented in FIG. 14. Further, the determination unit 3F performs determination between "0" and "1", by comparing the potential (the potential of the first output terminal Vout1 of the amplifier circuit 3E) of the first single electronic element 3A1 amplified by the amplifier circuit 3E with the potential (the potential of the second output terminal Vout2 of the amplifier circuit 3E) of the second single electronic element 3C1 amplified by the amplifier circuit 3E.

That is, in the example represented in FIG. 16, in the electronic circuit 3, the difference between the potential of the first single electronic element 3A1 and the potential of the second single electronic element 3C1 is read.

FIG. 17 is a diagram for explaining an example in which one single electronic element (the first single electronic element 3A1) among a plurality of single electronic elements included in the first single electronic element array 3A is used as the single electronic element 2A according to the above-described first to ninth embodiments, and one single electronic element (the second single electronic element 3C1) among a plurality of single electronic elements included in a second single electronic element array 3C is used as the single electronic element 2B in the first to ninth embodiments. Although FIG. 17 illustrates only a single electronic element, this is a case where the single electronic element is a charge quantum bit, and when applied to a spin quantum bit, each single electronic element works as a reading device of spin quantum bits.

The array structure of FIG. 17 can be applied from the first embodiment to the ninth embodiments, but, particularly in a case where the embodiment of FIG. 16 is applied in the array structure represented in FIG. 17, the first selector 3B selects the first single electronic element 3A1 (see FIG. 16) that functions in the same manner as the single electronic element 2A represented in FIG. 9, from the first single electronic element array 3A. The first single electronic element 3A1 selected by the first selector 3B is connected to the amplifier circuit 3E.

The second single electronic element array 3C is configured in the same manner as the first single electronic element array 3A. The second selector 3D is configured in the same manner as the first selector 3B. The second selector 3D selects the second single electronic element 3C1 (see FIG. 16) that functions in the same manner as the single electronic element 2B represented in FIG. 9, from the second single electronic element array 3C. The second single electronic element 3C1 selected by the second selector 3D is connected to the amplifier circuit 3E.

The amplifier circuit 3E represented in FIG. 17 has the same function as the SRAM 2F represented in FIG. 9. The determination unit 3F represented in FIG. 17 functions in the same manner as the determination unit 2I represented in FIG. 9. That is, the determination unit 3F reads a difference between the potential (the potential at the first output terminal Vout1 of the amplifier circuit 3E) of the first single electronic element 3A1 selected by the first selector 3B and amplified by the amplifier circuit 3E (that is, output via the amplifier circuit 3E), and the potential (the potential at the second output terminal Vout2 of the amplifier circuit 3E) of the second single electronic element 3C1 selected by the second selector 3D and amplified by the amplifier circuit 3E (that is, output via the amplifier circuit 3E).

Specifically, the first output terminal Vout1 and the second output terminal Vout2 of the amplifier circuit 3E output the potential of the first single electronic element 3A1 amplified by the amplifier circuit 3E and the potential of the second single electronic element 3C1 amplified by the amplifier circuit 3E as, for example, inverted results such as "0" and "1". Further, the determination unit 3F performs determination between "0" and "1", by comparing the potential of the first single electronic element 3A1 amplified by the amplifier circuit 3E with the potential of the second single electronic element 3C1 amplified by the amplifier circuit 3E.

FIG. 19 is a diagram for explaining an example in which a NAND flash memory is used as the first single electronic element array 3A and a NAND flash memory is used as the second single electronic element array 3C in the electronic circuit 3 of the ninth embodiment. Specifically, FIG. 19 represents a relationship among a control gate, a floating gate, a tunnel oxide film, a source, a drain, and electrons of the NAND flash memory that functions as the first single electronic element array 3A.

Hereinabove, although the embodiments of the present invention are described in detail with reference to the drawings, a specific configuration is not limited to the embodiments and can be appropriately modified without departing from the gist of the present invention. The configurations described in each of the embodiments and each of the examples, which are described above, may be combined.

Although the present invention mainly describes in regard to the spin quantum bit, the present invention is established although all single electronic elements are replaced with charge quantum bit elements. For example, in the example represented in FIG. 16, the single electronic elements 3A1 and 3C1 themselves can be operated as charge quantum bits. FIG. 16 particularly represents a state where the charge quantum bit (3A1) and the charge quantum bit (3C1) are coupled through capacitance. The capacitance coupling between the charge quantum bit (3A1) and the charge quantum bit (3C1) acts as, for example, an Ising interaction as represented in Non Patent Document 8. This interaction does not work when the charge quantum bits are apart. In this manner, the single electrons to be paired may be close to each other and directly interact with each other via capacitance.

Further, although a PMOS is described as the first MOS transistor, an NMOS transistor may be used. Further, in the case of an NMOS transistor, the MOS transistor may be inserted between a single electronic element and the ground. In FIG. 17 and FIG. 19, adjacent charge quantum bits may interact.

All or a part of the functions of each unit included in the quantum device 1, the quantum bit readout device 2, or the electronic circuit 3 in the above-described embodiments may be realized by recording a program for realizing the functions on a computer-readable recording medium and causing a computer system to read and execute the program recorded on the recording medium. Note that, here, the "computer system" includes an OS and hardware such as a peripheral device.

In addition, the "computer-readable recording medium" refers to a portable medium such as a flexible disk, a magneto-optical disc, a read-only memory (ROM), or a compact disc read-only memory (CD-ROM), or a storage unit such as a hard disk incorporated in the computer system. Furthermore, the "computer-readable recording medium" may include a medium dynamically holding the program for a short time period, such as a communication line in a case of transmitting the program through a network such as the Internet or a communication line such as a telephone line, and a medium holding the program for a certain time period, such as a volatile memory inside the computer system used as a server or a client in the case of transmitting the program. In addition, the program may be provided to realize a part of the above-described functions, or may be provided to be capable of realizing the above-described functions in combination with a program already recorded in the computer system.

In the above embodiment, the state of the spin quantum bit output from the quantum circuit 1A and inputting the input signal of the quantum circuit 1A to the input signal of the quantum circuit 1B, for example, through an inverter (that is, by using the inverted one of the input signal of the quantum circuit 1A as the input signal of the quantum circuit 1B), are described, but this often indicates that the spin direction of one spin quantum dot is opposite to the spin direction of the other spin quantum dot.

In addition, for the input portion, in the example of the spin quantum bit in the drawings so far, a state is considered in which the down spin can be entered when the spin state in one quantum dot of the two quantum dots is up. This utilizes a fact that, in a case where there are electrons in the quantum dot adjacent to the single electronic element, it is difficult for a current of the single electronic element to flow. That is, it utilizes the equivalent fact that the gate voltage of the single electronic element shifts depending on the presence or absence of electrons next to the single electronic element. FIG. 20 represents a schematic view of this situation and represents that the peak position of the Coulomb vibration shifts depending on the presence or absence of charges. In the above-described embodiment, the shift amount is described as the difference in the gate voltage of the single electronic element. The number of electrodes that control the single electronic element may be two or more.

Furthermore, this is an example, and for example, a case may be employed in which only one spin quantum dot is in contact with the single electronic element as described in Non Patent Document 7.

In the above description, the number of quantum bits in the quantum circuit 1B may not necessarily be equal to the number of quantum bits in the quantum circuit 1A. In this case, the quantum state of the quantum bit in the quantum circuit 1B is fixed to 0 or 1, and the quantum state of the quantum bit in the quantum circuit 1A can be determined as a collection of quantum bits to be referred to.

### REFERENCE SIGNS LIST

1: Quantum device
1A: Quantum circuit
1B: Quantum circuit
1C: Latch circuit
1D: Determination unit
2: Quantum bit readout device
2A: Single electronic element
2B: Single electronic element
2C: Amplifier circuit
2C1: Transistor
2C2: Transistor
2D: Amplifier circuit
2D1: Transistor
2D2: Transistor
2E: Differential amplifier circuit
2E1, 2E2, 2E3, 2E4, 2E5, 2E6, 2E7: Transistor
2E11, 2E12: Bipolar transistor
2E13, 2E14, 2E15, 2E16: Resistor
2E17: Constant current source
2F: SRAM
2F1, 2F2: Access transistor
2F3, 2F4: Inverter
2G: Amplifier circuit
2G1: Sense amplifier
2G2: Equalizer
2G3, 2G4: Transistor
2H: Cross-coupled MOS transistor circuit
2H1, 2H2: P-channel MOS transistor
2H3, 2H4: Transistor
2I: Determination unit
3: Electronic circuit
3A: First single electronic element array
3A1: Single electronic element
3B: First selector
3C: Second single electronic element array
3C2: Single electronic element
3D: Second selector
3E: Amplifier circuit
3F: Determination unit

## Claims

1. A quantum device comprising:
a first quantum circuit;
a second quantum circuit; and
a latch circuit connected to the first quantum circuit and the second quantum circuit,
wherein the latch circuit has
a function of latching a state of a first quantum bit output from the first quantum circuit and amplifying a signal indicating the state of the first quantum bit, and
a function of latching a state of a second quantum bit output from the second quantum circuit and amplifying a signal indicating the state of the second quantum bit.

2. A quantum bit readout device comprising:
a first single electronic element connected to a first quantum circuit;
a second single electronic element connected to a second quantum circuit; and
a differential amplifier circuit connected to the first single electronic element and the second single electronic element,
wherein a difference between a potential of the first single electronic element and a potential of the second single electronic element amplified by the differential amplifier circuit is read.

3. The quantum bit readout device according to Claim 2, further comprising:
a first amplifier circuit disposed between the first single electronic element and the differential amplifier circuit; and
a second amplifier circuit disposed between the second single electronic element and the differential amplifier circuit.

4. The quantum bit readout device according to Claim 3,
wherein the first amplifier circuit includes a first conductive transistor and a second conductive transistor, and
the second amplifier circuit includes a first conductive transistor and a second conductive transistor.

5. A quantum bit readout device comprising:
a first single electronic element connected to a first quantum circuit;
a second single electronic element connected to a second quantum circuit; and
a static random access memory (SRAM) connected to the first single electronic element and the second single electronic element,
wherein a difference between a potential of the first single electronic element and a potential of the second single electronic element output via the SRAM is read.

6. The quantum bit readout device according to Claim 5,
wherein the SRAM includes
a first access transistor connected to the first single electronic element,
a second access transistor connected to the second single electronic element,
a first inverter connected to the first access transistor, and
a second inverter connected to the second access transistor, and
the first inverter and the second inverter are cross-coupled.

7. The quantum bit readout device according to Claim 5, further comprising:
a first amplifier circuit disposed between the first single electronic element and the SRAM; and
a second amplifier circuit disposed between the second single electronic element and the SRAM.

8. A quantum bit readout device comprising:
an amplifier circuit connected to a first single electronic element connected to a first quantum circuit and a second single electronic element connected to a second quantum circuit,
wherein a difference between a potential of the first single electronic element and a potential of the second single electronic element output via the amplifier circuit is read.

9. The quantum bit readout device according to Claim 8,
wherein the amplifier circuit includes a sense amplifier and an equalizer.

10. A quantum bit readout device comprising:
a first single electronic element connected to a first quantum circuit;
a second single electronic element connected to a second quantum circuit; and
a cross-coupled MOS transistor circuit connected to the first single electronic element and the second single electronic element,
wherein the cross-coupled MOS transistor circuit includes a pair of cross-coupled P-channel MOS transistors, and
a difference between a potential of the first single electronic element and a potential of the second single electronic element, which are output via the cross-coupled MOS transistor circuit is read.

11. The quantum bit readout device according to Claim 2,
wherein the differential amplifier circuit includes
a first bipolar transistor having a base connected to the first single electronic element, and
a second bipolar transistor having a base connected to the second single electronic element.

12. The quantum bit readout device according to any one of Claims 2 to 11,
wherein the potential of the first single electronic element and the potential of the second single electronic element are output as a result of inversion.

13. The quantum bit readout device according to any one of Claims 2 to 12, further comprising:
a determination unit configured to perform determination between 0 and 1 by comparing the potential of the first single electronic element with the potential of the second single electronic element.

14. An electronic circuit comprising:
a first single electronic element array including a plurality of single electronic elements;
a first selector configured to select a first single electronic element, which is one single electronic element, from the first single electronic element array;
a second single electronic element array including a plurality of single electronic elements;
a second selector configured to select a second single electronic element, which is one single electronic element, from the second single electronic element array; and
an amplifier circuit configured to amplify a potential of the first single electronic element selected by the first selector and a potential of the second single electronic element selected by the second selector,
wherein a difference between the potential of the first single electronic element and the potential of the second single electronic element is read.

15. The electronic circuit according to Claim 14, further comprising:
a determination unit configured to perform determination between 0 and 1 by comparing the potential of the first single electronic element with the potential of the second single electronic element.
